# EUROPEAN PATENT APPLICATION

(11) **EP 3 726 235 A1**
(43) Date of publication of application: **21.10.2020**
(21) Application number: 18889482.8
(22) Date of filing: 28.08.2018
(51) Int. Cl.: G01R 31/36, H01M 10/48, H02J 7/00

(54) **BATTERY MONITORING DEVICE, COMPUTER PROGRAM, AND BATTERY MONITORING METHOD**

(30) Priority: 13.12.2017 JP 2017238642; 13.12.2017 JP 2017238643
(71) Applicant: SUMITOMO ELECTRIC INDUSTRIES, LTD., Osaka-shi, Osaka 541-0041 (JP)
(72) Inventor: KATAOKA, Tomomi, Osaka-shi, Osaka 541-0041 (JP); TAKECHI, Hiroaki, Osaka-shi, Osaka 541-0041 (JP)
(74) Representative: Boult Wade Tennant LLP
(86) International application number: PCT/JP2018/031676
(87) International publication number: WO 2019/116640

(57) **Abstract**

A battery monitoring device includes: a voltage acquisition unit configured to acquire voltages of a plurality of unit cells; a current acquisition unit configured to acquire a charge/discharge current of a secondary battery; a first state-of-charge calculation unit configured to calculate a first state of charge on the basis of a first voltage acquired at a first time at which a predetermined switch is in an OFF state, in a first trip period; a second state-of-charge calculation unit configured to calculate a second state of charge on the basis of a second voltage acquired at a second time at which the predetermined switch is in an OFF state, in a second trip period; a charge/discharge amount calculation unit configured to calculate a charge/discharge amount of the secondary battery from the first time to the second time; a full charge capacity calculation unit configured to calculate a unit full charge capacity of each of the plurality of unit cells on the basis of the first state of charge, the second state of charge, and the charge/discharge amount; and an update unit configured to update a full charge capacity of the secondary battery on the basis of the calculated unit full charge capacity.

## Description

### TECHNICAL FIELD

The present disclosure relates to a battery monitoring device, a computer program, and a battery monitoring method.

The present application claims priority based on Japanese Patent Application No. 2017-238642 filed on December 13, 2017 and Japanese Patent Application No. 2017-238643 filed on December 13, 2017, the entire contents of which are incorporated herein by reference.

### BACKGROUND ART

PATENT LITERATURE 1 discloses a full charge capacity calculation device that calculates a charge/discharge amount of a battery during one trip from the time when a starting switch of a vehicle is turned on until the starting switch is turned off and also measures the voltages of battery cells immediately after the starting switch is turned on, thereby calculating the difference between the remaining capacity of each battery cell calculated at the start of the present trip and the remaining capacity of each battery cell calculated at the start of the last trip and calculating the full charge capacity of the battery.

### CITATION LIST

### [PATENT LITERATURE]

PATENT LITERATURE 1: Japanese Laid-Open Patent Publication No. 2015-83928

### SUMMARY OF INVENTION

A battery monitoring device according to an embodiment of the present disclosure is a battery monitoring device for monitoring a full charge capacity of a secondary battery including a plurality of unit cells, the battery monitoring device including: a voltage acquisition unit configured to acquire voltages of the plurality of unit cells; a current acquisition unit configured to acquire a charge/discharge current of the secondary battery; a first state-of-charge calculation unit configured to calculate a first state of charge on the basis of a first voltage acquired by the voltage acquisition unit at a first time at which a predetermined switch for charging/discharging operation of the secondary battery is in an OFF state, in a first trip period from a turn-on time of the predetermined switch to a next turn-on time of the predetermined switch; a second state-of-charge calculation unit configured to calculate a second state of charge on the basis of a second voltage acquired by the voltage acquisition unit at a second time at which the predetermined switch is in an OFF state, in a second trip period that is a trip period next to the first trip period; a charge/discharge amount calculation unit configured to calculate a charge/discharge amount of the secondary battery on the basis of the charge/discharge current acquired by the current acquisition unit from the first time to the second time; a full charge capacity calculation unit configured to calculate a unit full charge capacity of each of the plurality of unit cells on the basis of the first state of charge, the second state of charge, and the charge/discharge amount; and an update unit configured to update the full charge capacity of the secondary battery on the basis of the unit full charge capacity calculated by the full charge capacity calculation unit.

A computer program according to an embodiment of the present disclosure is a computer program for causing a computer to monitor a full charge capacity of a secondary battery including a plurality of unit cells, the computer program causing the computer to perform: a process of acquiring voltages of the plurality of unit cells; a process of acquiring a charge/discharge current of the secondary battery; a process of calculating a first state of charge on the basis of a voltage acquired at a first time at which a predetermined switch for charging/discharging operation of the secondary battery is in an OFF state, in a first trip period from a turn-on time of the predetermined switch to a next turn-on time of the predetermined switch; a process of calculating a second state of charge on the basis of a second voltage acquired at a second time at which the predetermined switch is in an OFF state, in a second trip period that is a trip period next to the first trip period; a process of calculating a charge/discharge amount of the secondary battery on the basis of the charge/discharge current acquired from the first time to the second time; a process of calculating a unit full charge capacity of each of the plurality of unit cells on the basis of the first state of charge, the second state of charge, and the charge/discharge amount; and a process of updating the full charge capacity of the secondary battery on the basis of the calculated unit full charge capacity.

A battery monitoring method according to an embodiment of the present disclosure is a battery monitoring method by a battery monitoring device for monitoring a full charge capacity of a secondary battery including a plurality of unit cells, the battery monitoring method including: acquiring voltages of the plurality of unit cells; acquiring a charge/discharge current of the secondary battery; calculating a first state of charge on the basis of a voltage acquired at a first time at which a predetermined switch for charging/discharging operation of the secondary battery is in an OFF state, in a first trip period from a turn-on time of the predetermined switch to a next turn-on time of the predetermined switch; calculating a second state of charge on the basis of a voltage acquired at a second time at which the predetermined switch is in an OFF state, in a second trip period that is a trip period next to the first trip period; calculating a charge/discharge amount of the secondary battery on the basis of the charge/discharge current acquired from the first time to the second time; calculating a unit full charge capacity of each of the plurality of unit cells on the basis of the first state of charge, the second state of charge, and the charge/discharge amount; and updating the full charge capacity of the secondary battery on the basis of the calculated unit full charge capacity.

A battery monitoring device according to an embodiment of the present disclosure is a battery monitoring device for monitoring a full charge capacity of a secondary battery including a plurality of unit cells, the battery monitoring device including: a current acquisition unit configured to acquire a current of the secondary battery; a current accumulated value calculation unit configured to calculate a current accumulated value of the secondary battery from a predetermined start time to an end time; a specification unit configured to specify a first time and a second time on the basis of an absolute value of a difference in the current accumulated value calculated by the current accumulated value calculation unit; a state-of-charge calculation unit configured to calculate states of charge of each of the plurality of unit cells at the first time and the second time specified by the specification unit; and a full charge capacity calculation unit configured to calculate a unit full charge capacity of each of the plurality of unit cells on the basis of the difference in the current accumulated value and the states of charge at the first time and the second time.

A computer program according to an embodiment of the present disclosure is a computer program for causing a computer to monitor a full charge capacity of a secondary battery including a plurality of unit cells, the computer program causing the computer to perform: a process of acquiring a current of the secondary battery; a process of calculating a current accumulated value of the secondary battery from a predetermined start time to an end time; a process of specifying a first time and a second time on the basis of an absolute value of a difference in the calculated current accumulated value; a process of calculating states of charge of each of the plurality of unit cells at the specified first time and second time; and a process of calculating a unit full charge capacity of each of the plurality of unit cells on the basis of the absolute value of the difference in the current accumulated value and the states of charge at the first time and the second time.

A battery monitoring method according to an embodiment of the present disclosure is a battery monitoring method by a battery monitoring device for monitoring a full charge capacity of a secondary battery including a plurality of unit cells, the battery monitoring method including: acquiring a current of the secondary battery; calculating a current accumulated value of the secondary battery from a predetermined start time to an end time; specifying a first time and a second time on the basis of an absolute value of a difference in the calculated current accumulated value; calculating states of charge of each of the plurality of unit cells at the specified first time and second time; and calculating a unit full charge capacity of each of the plurality of unit cells on the basis of the absolute value of the difference in the current accumulated value and the states of charge at the first time and the second time.

### BRIEF DESCRIPTION OF DRAWINGS

FIG. 1 is a block diagram showing an example of the configuration of a main part of a vehicle equipped with a battery monitoring device of an embodiment.
FIG. 2 is a block diagram showing an example of the configuration of the battery monitoring device of the embodiment.
FIG. 3 is a time chart showing an example of operation of the battery monitoring device of the embodiment.
FIG. 4 illustrates an example of a correlation between the open-circuit voltage and the state of charge of a cell of the embodiment.
FIG. 5 is a schematic diagram showing an example of a change in voltage of the cell after the end of charging.
FIG. 6 is a schematic diagram showing an example of a change in voltage of the cell after the end of discharging.
FIG. 7 illustrates an example of a history of a unit full charge capacity of each cell.
FIG. 8 illustrates a first example of a method for updating a secondary battery unit by the battery monitoring device of the embodiment.
FIG. 9 illustrates a second example of the method for updating the secondary battery unit by the battery monitoring device of the embodiment
FIG. 10 is a flowchart showing an example of a process procedure for calculating a unit full charge capacity by the battery monitoring device of the embodiment.
FIG. 11 is a flowchart showing the example of the process procedure for calculating a unit full charge capacity by the battery monitoring device of the embodiment.
FIG. 12 is a flowchart showing an example of a process procedure for updating a full charge capacity by the battery monitoring device of the embodiment.
FIG. 13 is a block diagram showing an example of the configuration of the battery monitoring device of the embodiment.
FIG. 14 illustrates an example of an equivalent circuit of the cell of the embodiment.
FIG. 15 illustrates an example of an impedance spectrum of the cell of the embodiment.
FIG. 16 illustrates an example of a state of change in current and voltage of the cell of the embodiment before and after switching between charging and discharging.
FIG. 17 is a time chart showing a first example of transition of a current accumulated value of the cell of the embodiment in one trip.
FIG. 18 is a time chart showing a second example of transition of a current accumulated value of the cell of the embodiment in one trip.
FIG. 19 illustrates a list of methods for calculating a charge/discharge amount and a difference in state of charge by the battery monitoring device of the embodiment.
FIG. 20 is a flowchart showing an example of a process procedure for calculating a state of charge and a current accumulated value by the battery monitoring device of the embodiment.
FIG. 21 is a flowchart showing the example of the process procedure for calculating a state of charge and a current accumulated value by the battery monitoring device of the embodiment.
FIG. 22 is a flowchart showing an example of a process procedure for calculating a unit full charge capacity by the battery monitoring device of the embodiment.
FIG. 23 is a flowchart showing an example of a process procedure for updating a full charge capacity by the battery monitoring device of the embodiment.

### DESCRIPTION OF EMBODIMENTS

### [Problems to be solved by the present disclosure]

In the device of PATENT LITERATURE 1, the open-circuit voltage of each battery cell is measured on the premise that no current flows through the battery cell immediately after the starting switch is turned on. However, in actuality, even immediately after the starting switch is turned on, a monitoring unit for monitoring each battery cell may be activated, or a current may flow from the battery cell to monitor an inverter, a motor, or the like. In such a case, the open-circuit voltage cannot be accurately measured. Thus, as a result, the full charge capacity of the battery cannot be accurately calculated. In addition, when a process of equalizing the remaining capacity of each battery cell is being performed, a discharge current flows from the battery cell, and it is unknown whether the voltage of the battery cell is stable immediately after the starting switch is turned on, so that the full charge capacity of the battery may not be able to be accurately calculated.

Therefore, it is an object to provide a battery monitoring device, a computer program, and a battery monitoring method that allow the full charge capacity of a secondary battery to be accurately calculated.

### [Effects of the present disclosure]

According to the present disclosure, the full charge capacity of the secondary battery can be accurately calculated.

### [Description of first embodiment of the present disclosure]

A battery monitoring device according to an embodiment is a battery monitoring device for monitoring a full charge capacity of a secondary battery including a plurality of unit cells, the battery monitoring device including: a voltage acquisition unit configured to acquire voltages of the plurality of unit cells; a current acquisition unit configured to acquire a charge/discharge current of the secondary battery; a first state-of-charge calculation unit configured to calculate a first state of charge on the basis of a first voltage acquired by the voltage acquisition unit at a first time at which a predetermined switch for charging/discharging operation of the secondary battery is in an OFF state, in a first trip period from a turn-on time of the predetermined switch to a next turn-on time of the predetermined switch; a second state-of-charge calculation unit configured to calculate a second state of charge on the basis of a second voltage acquired by the voltage acquisition unit at a second time at which the predetermined switch is in an OFF state, in a second trip period that is a trip period next to the first trip period; a charge/discharge amount calculation unit configured to calculate a charge/discharge amount of the secondary battery on the basis of the charge/discharge current acquired by the current acquisition unit from the first time to the second time; a full charge capacity calculation unit configured to calculate a unit full charge capacity of each of the plurality of unit cells on the basis of the first state of charge, the second state of charge, and the charge/discharge amount; and an update unit configured to update the full charge capacity of the secondary battery on the basis of the unit full charge capacity calculated by the full charge capacity calculation unit.

A computer program according to an embodiment is a computer program for causing a computer to monitor a full charge capacity of a secondary battery including a plurality of unit cells, the computer program causing the computer to perform: a process of acquiring voltages of the plurality of unit cells; a process of acquiring a charge/discharge current of the secondary battery; a process of calculating a first state of charge on the basis of a voltage acquired at a first time at which a predetermined switch for charging/discharging operation of the secondary battery is in an OFF state, in a first trip period from a turn-on time of the predetermined switch to a next turn-on time of the predetermined switch; a process of calculating a second state of charge on the basis of a voltage acquired at a second time at which the predetermined switch is in an OFF state, in a second trip period that is a trip period next to the first trip period; a process of calculating a charge/discharge amount of the secondary battery on the basis of the charge/discharge current acquired from the first time to the second time; a process of calculating a unit full charge capacity of each of the plurality of unit cells on the basis of the first state of charge, the second state of charge, and the charge/discharge amount; and a process of updating the full charge capacity of the secondary battery on the basis of the calculated unit full charge capacity.

A battery monitoring method according to an embodiment is a battery monitoring method by a battery monitoring device for monitoring a full charge capacity of a secondary battery including a plurality of unit cells, the battery monitoring method including: acquiring voltages of the plurality of unit cells; acquiring a charge/discharge current of the secondary battery; calculating a first state of charge on the basis of a voltage acquired at a first time at which a predetermined switch for charging/discharging operation of the secondary battery is in an OFF state, in a first trip period from a turn-on time of the predetermined switch to a next turn-on time of the predetermined switch; calculating a second state of charge on the basis of a voltage acquired at a second time at which the predetermined switch is in an OFF state, in a second trip period that is a trip period next to the first trip period; calculating a charge/discharge amount of the secondary battery on the basis of the charge/discharge current acquired from the first time to the second time; calculating a unit full charge capacity of each of the plurality of unit cells on the basis of the first state of charge, the second state of charge, and the charge/discharge amount; and updating the full charge capacity of the secondary battery on the basis of the calculated unit full charge capacity.

The secondary battery (also referred to as secondary battery unit) has a configuration in which a plurality of single unit cells (also referred to as battery cells) or a plurality of sets of unit cells connected in parallel are connected in series. The voltage acquisition unit acquires the voltage of each of the plurality of unit cells connected in series. The current acquisition unit acquires the charge/discharge current of the secondary battery.

The first state-of-charge calculation unit calculates a first state of charge on the basis of a first voltage acquired by the voltage acquisition unit at a first time at which a predetermined switch for charging/discharging operation of the secondary battery is in an OFF state, in a first trip period from a turn-on time of the predetermined switch to a next turn-on time of the predetermined switch. A trip indicates a period from a time at which the predetermined switch is turned on to a time at which the predetermined switch is turned on next after the predetermined switch is turned off once. The predetermined switch can be, for example, a starting switch of a vehicle. The voltage acquisition unit acquires the voltage (open-circuit voltage: OCV) of each unit cell at the first time. On the basis of a predetermined relationship between the OCV and the state of charge: SOC of the unit cell, a state of charge: SOC can be calculated from an OCV.

The second state-of-charge calculation unit calculates a second state of charge on the basis of a second voltage acquired by the voltage acquisition unit at a second time at which the predetermined switch is in an OFF state, in a second trip period that is a trip period next to the first trip period. The first state of charge is represented as SOC1, and the second state of charge is represented as SOC2.

The charge/discharge amount calculation unit calculates a charge/discharge amount of the secondary battery on the basis of the charge/discharge current acquired by the current acquisition unit from the first time to the second time. The charge/discharge amount from the first time to the second time is represented as ΔC.

The full charge capacity calculation unit calculates a unit full charge capacity of each of the plurality of unit cells on the basis of the first state of charge SOC1, the second state of charge SOC2, and the charge/discharge amount ΔC.When the unit full charge capacity is represented as F, the unit full charge capacity F can be calculated by the formula, F = ΔC/ΔSOC (where ΔSOC = SOC2 - SOC1).

The update unit updates the full charge capacity of the secondary battery on the basis of the unit full charge capacity calculated by the full charge capacity calculation unit. For example, the full charge capacity of the secondary battery can be calculated by summing up the unit full charge capacities of the respective unit cells.

As described above, the voltage of each unit cell at a time at which the predetermined switch is in an OFF state is acquired, and thus no charge/discharge current flows through each unit cell. Therefore, an accurate open-circuit voltage of each unit cell can be obtained. As a result, the full charge capacity of the secondary battery can be accurately calculated.

In the battery monitoring device according to the present embodiment, the update unit updates the full charge capacity of the secondary battery on the basis of a unit full charge capacity calculated by the full charge capacity calculation unit at one time and a unit full charge capacity calculated by the full charge capacity calculation unit at a time previous to the one time.

The update unit updates the full charge capacity of the secondary battery on the basis of a unit full charge capacity calculated by the full charge capacity calculation unit at one time (for example, referred to as this time) and a unit full charge capacity calculated by the full charge capacity calculation unit at a time previous to the one time (for example, referred to as last time).

For example, regarding an arbitrary unit cell, if the unit full charge capacity at this time is greater than the unit full charge capacity at the last time, it is considered that some error has occurred, in view of the fact that the full charge capacity decreases over time, and, thus, the unit full charge capacity at this time is not used, and the unit full charge capacity at the last time is used. On the other hand, if the unit full charge capacity at this time is equal to or less than the unit full charge capacity at the last time, the full charge capacity of the unit cell is updated with the full charge capacity at this time. Accordingly, the unit full charge capacity of the unit cell can be accurately updated.

The battery monitoring device according to the present embodiment includes: a storage unit configured to store the unit full charge capacity of each of the plurality of unit cells each time the unit full charge capacity of each of the plurality of unit cells is calculated by the full charge capacity calculation unit; and a statistical value calculation unit configured to calculate a statistical value related to unit full charge capacity on the basis of unit full charge capacities for a predetermined number of times in the past stored in the storage unit, and the update unit updates the full charge capacity of the secondary battery on the basis of a statistical value calculated by the statistical value calculation unit at one time and a statistical value calculated by the statistical value calculation unit at a time previous to the one time.

The storage unit stores the unit full charge capacity of each of the plurality of unit cells each time the unit full charge capacity of each of the plurality of unit cells is calculated by the full charge capacity calculation unit.

The statistical value calculation unit calculates a statistical value related to unit full charge capacity on the basis of the unit full charge capacities for a predetermined number of times in the past stored in the storage unit. The predetermined number of times can be, for example, 5 times, 10 times, or the like from this time (or present time) toward the past, but is not limited to 5 times and 10 times, and may be several times from the viewpoint of reducing errors. The statistical value can be, for example, an average value but is not limited to the average value.

For example, assuming that unit full charge capacities of an arbitrary unit cell are Fn, F(n - 1), F(n - 2), F(n - 3), and F(n - 4) toward the past, the statistical value can be calculated by the formula, {Fn + F(n - 1) + F(n - 2) + F(n - 3) + F(n - 4)}/5.

The update unit updates the full charge capacity of the secondary battery on the basis of a statistical value calculated by the statistical value calculation unit at one time (for example, referred to as this time) and a statistical value calculated by the statistical value calculation unit at a time previous to the one time (for example, referred to as last time).

For example, regarding an arbitrary unit cell, if the statistical value of the unit full charge capacity at this time is greater than the statistical value of the unit full charge capacity at the last time, it is considered that some error has occurred, in view of the fact that the full charge capacity decreases over time, and thus the statistical value at this time is not used. On the other hand, if the statistical value of the unit full charge capacity at this time is equal to or less than the statistical value of the unit full charge capacity at the last time, the full charge capacity of the secondary battery is updated using the statistical value at this time as the unit full charge capacity of the unit cell. Accordingly, an error can be reduced, and the full charge capacity of the secondary battery can be accurately updated.

In the battery monitoring device according to the present embodiment, if the statistical value at the one time is greater than the statistical value at the previous time, the update unit does not update the full charge capacity of the secondary battery.

If the statistical value at the one time is greater than the statistical value at the previous time, the update unit does not update the full charge capacity of the secondary battery. For example, if the statistical value of the unit full charge capacity at this time is greater than the statistical value of the unit full charge capacity at the last time, it is considered that some error has occurred, in view of the fact that the full charge capacity decreases over time, and, thus, the statistical value at this time is not used, and the full charge capacity of the secondary battery is not updated. Accordingly, the accuracy of the full charge capacity of the secondary battery can be prevented from decreasing.

In the battery monitoring device according to the present embodiment, if the statistical value at the one time is equal to or less than the statistical value at the previous time, the update unit updates the full charge capacity of the secondary battery on the basis of the statistical value.

If the statistical value at the one time is equal to or less than the statistical value at the previous time, the update unit updates the full charge capacity of the secondary battery on the basis of the statistical value. For example, if the statistical value of the unit full charge capacity at this time is equal to or less than the statistical value of the unit full charge capacity at the last time, since the full charge capacity of the secondary battery is updated, the full charge capacity that decreases over time can be reflected and the full charge capacity of the secondary battery can be accurately obtained.

In the battery monitoring device according to the present embodiment, if the statistical value at the one time is greater than a nominal full charge capacity, the update unit updates the full charge capacity of the secondary battery on the basis of the statistical value.

If the statistical value at the one time is greater than a nominal full charge capacity, the update unit updates the full charge capacity of the secondary battery on the basis of the statistical value.

The actual full charge capacity (actual value) of a battery is generally greater than the nominal full charge capacity thereof in consideration of variations in battery production and the like. In particular, when the unit cell (or the secondary battery) is new or nearly new, the unit full charge capacity of the unit cell is often greater than the nominal full charge capacity thereof. Therefore, if the statistical value is greater than the nominal full charge capacity, the full charge capacity of the secondary battery is updated on the basis of the statistical value.

For example, assuming that the nominal full charge capacity is FN and the calculated full charge capacity is F (= FN + ΔF), by setting the full charge capacity of the secondary battery to F and not to FN, it is made possible to perform regeneration by the capacity corresponding to ΔF, so that the range where regeneration is possible can be expanded.

In the battery monitoring device according to the present embodiment, if the statistical value at the one time is equal to or less than the nominal full charge capacity and greater than the statistical value at the previous time, the update unit does not update the full charge capacity of the secondary battery.

If the statistical value at the one time is equal to or less than the nominal full charge capacity and greater than the statistical value at the previous time, the update unit does not update the full charge capacity of the secondary battery. If the statistical value is equal to or less than the nominal full charge capacity, there is no room to expand the range where regeneration is possible, as when the statistical value is greater than the nominal full charge capacity. Furthermore, if the statistical value of the unit full charge capacity at this time is greater than the statistical value of the unit full charge capacity at the last time, it is considered that some error has occurred, and, thus, the statistical value at this time is not used, and the full charge capacity of the secondary battery is not updated. Accordingly, the accuracy of the full charge capacity of the secondary battery can be prevented from decreasing.

In the battery monitoring device according to the present embodiment, if the statistical value at the one time is equal to or less than the nominal full charge capacity and equal to or less than the statistical value at the previous time, the update unit updates the full charge capacity of the secondary battery on the basis of the statistical value.

If the statistical value at the one time is equal to or less than the nominal full charge capacity and equal to or less than the statistical value at the previous time, the update unit updates the full charge capacity of the secondary battery on the basis of the statistical value. If the statistical value is equal to or less than the nominal full charge capacity, there is no room to expand the range where regeneration is possible, as when the statistical value is greater than the nominal full charge capacity. Furthermore, if the statistical value of the unit full charge capacity at this time is equal to or less than the statistical value of the unit full charge capacity at the last time, since the full charge capacity of the secondary battery is updated, the full charge capacity that decreases over time can be reflected and the full charge capacity of the secondary battery can be accurately obtained.

In the battery monitoring device according to the present embodiment, the statistical value calculation unit calculates a statistical value related to unit full charge capacity on the basis of a minimum value, for each of the predetermined number of times in the past, among the respective unit full charge capacities of the plurality of unit cells stored in the storage unit.

The statistical value calculation unit calculates a statistical value related to unit full charge capacity on the basis of a minimum value, for each of the predetermined number of times in the past, among the respective unit full charge capacities of the plurality of unit cells stored in the storage unit.

For example, assuming that, among the respective unit full charge capacities of the plurality of unit cells, the minimum values of the unit full charge capacities are Fn, F(n - 1), F(n - 2), F(n - 3), and F(n - 4) toward the past, the statistical value can be calculated by the formula, {Fn + F(n - 1) + F(n - 2) + F(n - 3) + F(n - 4)}/5. When the respective unit full charge capacities of the plurality of unit cells are different, the full charge capacity of the secondary battery often depends on the minimum value of the unit full charge capacities of the plurality of unit cells. With the above-described configuration, the full charge capacity of the secondary battery in which the plurality of unit cells are connected in series can be accurately obtained.

In the battery monitoring device according to the present embodiment, the voltage acquisition unit acquires the first voltage and the second voltage except a voltage acquired by the secondary battery during charging or during discharging.

The voltage acquisition unit acquires the first voltage and the second voltage except a voltage acquired by the secondary battery during charging or during discharging. In other words, the voltage acquisition unit acquires no voltage during charging or discharging of the secondary battery. Accordingly, the voltage (that is, the open-circuit voltage) when no current flows through the secondary battery (unit cells) can be acquired, and a state of charge (SOC) can be accurately calculated.

In the battery monitoring device according to the present embodiment, the voltage acquisition unit acquires the first voltage and the second voltage except a voltage acquired within a predetermined period from end of charging or discharging of the secondary battery or within a predetermined period from a turn-off time of the predetermined switch.

The voltage acquisition unit acquires the first voltage and the second voltage except a voltage acquired within a predetermined period from end of charging or discharging of the secondary battery or within a predetermined period from a turn-off time of the predetermined switch. Within a predetermined period after the end of charging, after the end of discharging, or after the predetermined switch is turned off, there is a possibility that the voltage of the unit cell is not stable. Thus, by acquiring the voltages after the voltage of the unit cell is stabilized, a state of charge (SOC) can be accurately calculated.

The battery monitoring device according to the present embodiment includes a voltage change rate calculation unit configured to calculate a voltage change rate of each of the plurality of unit cells after end of charging or discharging of the secondary battery or after a turn-off time of the predetermined switch, and the voltage acquisition unit acquires the first voltage and the second voltage except a voltage acquired when the voltage change rate calculated by the voltage change rate calculation unit is equal to or greater than a predetermined value.

The voltage change rate calculation unit calculates a voltage change rate of each of the plurality of unit cells after end of charging or discharging of the secondary battery or after a turn-off time of the predetermined switch.

The voltage acquisition unit acquires the first voltage and the second voltage except a voltage acquired when the voltage change rate calculated by the voltage change rate calculation unit is equal to or greater than a predetermined value. After the end of charging, after the end of discharging, or after the predetermined switch is turned off, there is a possibility that the voltage of the unit cell is not stable. Thus, by acquiring the voltages after the voltage of the unit cell is stabilized, a state of charge (SOC) can be accurately calculated.

The battery monitoring device according to the present embodiment includes a signal acquisition unit configured to acquire a signal related to balancing operation of remaining capacities of the plurality of unit cells, and the voltage acquisition unit acquires the first voltage and the second voltage except a voltage acquired when the signal acquired by the signal acquisition unit indicates that the balancing operation is being performed.

The signal acquisition unit acquires a signal related to balancing operation of remaining capacities of the plurality of unit cells. The balancing operation of the remaining capacities is also referred to as cell balance operation. A circuit that performs the balancing operation can individually discharge each unit cell, for example, by turning on a switch of a series circuit that includes a resistance element and the switch and that is connected in parallel to each cell, so that the remaining capacities can be equalized.

The voltage acquisition unit acquires the first voltage and the second voltage except a voltage acquired when the signal acquired by the signal acquisition unit indicates that the balancing operation is being performed. During the balancing operation, there is a possibility that the voltage of the unit cell is not stable. Thus, by acquiring the voltages when the balancing operation is not performed, a state of charge (SOC) can be accurately calculated.

### [Problems to be solved by the present disclosure]

Moreover, in the device of PATENT LITERATURE 1, when a charge/discharge amount during one trip is small, a calculation error of a full charge capacity may increase.

Therefore, it is an object to provide a battery monitoring device, a computer program, and a battery monitoring method that allow the full charge capacity of a secondary battery to be accurately calculated.

### [Effects of the present disclosure]

According to the present disclosure, the full charge capacity of the secondary battery can be accurately calculated.

### [Description of second embodiment of the present disclosure]

A battery monitoring device according to an embodiment is a battery monitoring device for monitoring a full charge capacity of a secondary battery including a plurality of unit cells, the battery monitoring device including: a current acquisition unit configured to acquire a current of the secondary battery; a current accumulated value calculation unit configured to calculate a current accumulated value of the secondary battery from a predetermined start time to an end time; a specification unit configured to specify a first time and a second time on the basis of an absolute value of a difference in the current accumulated value calculated by the current accumulated value calculation unit; a state-of-charge calculation unit configured to calculate states of charge of each of the plurality of unit cells at the first time and the second time specified by the specification unit; and a full charge capacity calculation unit configured to calculate a unit full charge capacity of each of the plurality of unit cells on the basis of the difference in the current accumulated value and the states of charge at the first time and the second time.

A computer program according to an embodiment is a computer program for causing a computer to monitor a full charge capacity of a secondary battery including a plurality of unit cells, the computer program causing the computer to perform: a process of acquiring a current of the secondary battery; a process of calculating a current accumulated value of the secondary battery from a predetermined start time to an end time; a process of specifying a first time and a second time on the basis of an absolute value of a difference in the calculated current accumulated value; a process of calculating states of charge of each of the plurality of unit cells at the specified first time and second time; and a process of calculating a unit full charge capacity of each of the plurality of unit cells on the basis of the absolute value of the difference in the current accumulated value and the states of charge at the first time and the second time.

A battery monitoring method according to an embodiment is a battery monitoring method by a battery monitoring device for monitoring a full charge capacity of a secondary battery including a plurality of unit cells, the battery monitoring method including: acquiring a current of the secondary battery; calculating a current accumulated value of the secondary battery from a predetermined start time to an end time; specifying a first time and a second time on the basis of an absolute value of a difference in the calculated current accumulated value; calculating states of charge of each of the plurality of unit cells at the specified first time and second time; and calculating a unit full charge capacity of each of the plurality of unit cells on the basis of the absolute value of the difference in the current accumulated value and the states of charge at the first time and the second time.

The secondary battery (also referred to as secondary battery unit) has a configuration in which a plurality of single unit cells (also referred to as battery cells) or a plurality of sets of unit cells connected in parallel are connected in series. The current acquisition unit acquires the charge/discharge current of the secondary battery.

The current accumulated value calculation unit calculates a current accumulated value of the secondary battery from a predetermined start time to an end time. Assuming that the charge current of the secondary battery is positive and the discharge current of the secondary battery is negative, the current accumulated value increases during charging, and decreases during discharging. The predetermined start time can be, for example, a time at which a starting switch of a vehicle is turned on from an OFF state, and the end time can be a time at which the starting switch is turned off from an ON state. The turn-on time of the starting switch can include not only a turn-on time but also a short period in the proximity of before and after the turn-on time. In addition, the turn-off time of the starting switch can include not only a turn-off time but also a short period in the proximity of before and after the turn-off time.

The specification unit specifies a first time and a second time on the basis of an absolute value of a difference in the current accumulated value calculated by the current accumulated value calculation unit. The first time and the second time can be times at which the absolute value of the difference between the current accumulated values is greater than that of the difference between the current accumulated value at the start time and the current accumulated value at the end time.

The state-of-charge calculation unit calculates states of charge of each of the plurality of unit cells at the first time and the second time specified by the specification unit.

The full charge capacity calculation unit calculates a unit full charge capacity of each of the plurality of unit cells on the basis of the difference in the current accumulated value and the states of charge at the first time and the second time. When the difference in the current accumulated value is denoted by ΔC and the difference between the states of charge at the first time and the second time is denoted by ΔSOC, a unit full charge capacity F can be calculated by the formula ΔC/ΔSOC.

As described above, even if the difference between the current accumulated value at the start time and the current accumulated value at the end time is small, the first time and the second time at which the absolute value of the difference between the current accumulated values is greater than that of the difference between the current accumulated value at the start time and the current accumulated value at the end time are specified, and thus the difference ΔC in the current accumulated value can be inhibited from becoming small. As a result, the full charge capacity of the secondary battery can be accurately calculated.

The battery monitoring device according to the present embodiment includes a minimum value specification unit configured to specify a minimum time at which the current accumulated value calculated by the current accumulated value calculation unit becomes a minimum value, and the specification unit specifies the first time and the second time from the start time, the end time, and the minimum time.

The minimum value specification unit specifies a minimum time at which the current accumulated value calculated by the current accumulated value calculation unit becomes a minimum value. If the minimum value continues over time, the minimum time may be a time at which the current accumulated value reaches the minimum value for the first time, or may be any other time at which the minimum value is maintained.

The specification unit specifies the first time and the second time from the start time, the end time, and the minimum time. For example, the first time and the second time may be the start time and the minimum time, or may be the minimum time and the end time.

As described above, even if the difference between the current accumulated value at the start time and the current accumulated value at the end time is small, the minimum time at which the current accumulated value becomes a minimum value is specified, and thus the difference ΔC in the current accumulated value can be inhibited from becoming small. As a result, the full charge capacity of the secondary battery can be accurately calculated.

The battery monitoring device according to the present embodiment includes a maximum value specification unit configured to specify a maximum time at which the current accumulated value calculated by the current accumulated value calculation unit becomes a maximum value, and the specification unit specifies the first time and the second time from the start time, the end time, and the maximum time.

The maximum value specification unit specifies a maximum time at which the current accumulated value calculated by the current accumulated value calculation unit becomes a maximum value. If the maximum value continues over time, the maximum time may be a time at which the current accumulated value reaches the maximum value for the first time, or may be any other time at which the maximum value is maintained.

The specification unit specifies the first time and the second time from the start time, the end time, and the maximum time. For example, the first time and the second time may be the start time and the maximum time, may be the maximum time and the end time, or may be the minimum time and the maximum time.

As described above, even if the difference between the current accumulated value at the start time and the current accumulated value at the end time is small, the maximum time at which the current accumulated value becomes a maximum value is specified, and thus the difference ΔC in the current accumulated value can be inhibited from becoming small. As a result, the full charge capacity of the secondary battery can be accurately calculated.

The battery monitoring device according to the present embodiment includes: a voltage acquisition unit configured to acquire voltages of the plurality of unit cells; a resistance calculation unit configured to calculate internal resistances of the plurality of unit cells; and an open-circuit voltage calculation unit configured to calculate open-circuit voltages of the plurality of unit cells on the basis of the current of the secondary battery and the voltages and the internal resistances of the plurality of unit cells, and the state-of-charge calculation unit calculates the states of charge on the basis of the open-circuit voltages calculated by the open-circuit voltage calculation unit.

The voltage acquisition unit acquires voltages of the plurality of unit cells. The resistance calculation unit calculates internal resistances of the plurality of unit cells. When switching is made from charging to discharging or from discharging to charging, for example, the diffusion resistance (diffusion impedance) and the charge transfer resistance in the internal resistance of each unit cell are reset once, and the internal resistance starts to increase according to a current application time. Therefore, when it is determined that switching between charging and discharging has occurred, the internal resistance of each unit cell can be calculated by acquiring a voltage V2 and a current I2 after a standby time T. More specifically, when the voltage and the current of the unit cell before the switching between charging and discharging are denoted by V1 and I1, respectively, an internal resistance R can be calculated by R = (V2 - V1)/(I2 - I1).

The open-circuit voltage calculation unit calculates open-circuit voltages of the plurality of unit cells on the basis of the current of the secondary battery and the voltages and the internal resistances of the plurality of unit cells. The open-circuit voltage OCV of the unit cell can be calculated by the formula OCV = V2 - I2 × R. The voltage V2 and the current I2 are the voltage and the current when the internal resistance R is calculated.

The state-of-charge calculation unit calculates the states of charge on the basis of the open-circuit voltages calculated by the open-circuit voltage calculation unit. On the basis of a predetermined relationship between the OCV and the state of charge (SOC) of the unit cell, a state of charge can be calculated from an OCV.

With the above-described configuration, the state of charge of the unit cell required for calculating the full charge capacity can be calculated.

In the battery monitoring device according to the present embodiment, if an absolute value of a difference between a current accumulated value calculated by the current accumulated value calculation unit at the start time and a current accumulated value calculated by the current accumulated value calculation unit at the end time is smaller than a predetermined threshold, the specification unit specifies the first time and the second time.

If an absolute value of a difference between a current accumulated value calculated by the current accumulated value calculation unit at the start time and a current accumulated value calculated by the current accumulated value calculation unit at the end time is smaller than a predetermined threshold, the specification unit specifies the first time and the second time.

As described above, the difference ΔC in the current accumulated value can be inhibited from becoming small. As a result, the full charge capacity of the secondary battery can be accurately calculated.

The battery monitoring device according to the present embodiment includes an update unit configured to update the full charge capacity of the secondary battery on the basis of the unit full charge capacity calculated by the full charge capacity calculation unit.

The update unit updates the full charge capacity of the secondary battery on the basis of the unit full charge capacity calculated by the full charge capacity calculation unit. For example, when the secondary battery is composed of unit cells connected in series, the full charge capacity of the secondary battery can be a unit full charge capacity, and, when the secondary battery is composed of unit cells connected in parallel, the full charge capacity of the secondary battery can be unit full charge capacity × number of unit cells connected in parallel. As a result, the full charge capacity of the secondary battery can be accurately calculated.

In the battery monitoring device according to the present embodiment, the update unit updates the full charge capacity of the secondary battery on the basis of a unit full charge capacity calculated by the full charge capacity calculation unit at one time and a unit full charge capacity calculated by the full charge capacity calculation unit at a time previous to the one time.

The update unit updates the full charge capacity of the secondary battery on the basis of a unit full charge capacity calculated by the full charge capacity calculation unit at one time (for example, referred to as this time) and a unit full charge capacity calculated by the full charge capacity calculation unit at a time previous to the one time (for example, referred to as last time).

For example, regarding an arbitrary unit cell, if the unit full charge capacity at this time is greater than the unit full charge capacity at the last time, it is considered that some error has occurred, in view of the fact that the full charge capacity decreases over time, and, thus, the unit full charge capacity at this time is not used, and the unit full charge capacity at the last time is used. On the other hand, if the unit full charge capacity at this time is equal to or less than the unit full charge capacity at the last time, the full charge capacity of the unit cell is updated with the full charge capacity at this time. Accordingly, the unit full charge capacity of the unit cell can be accurately updated.

The battery monitoring device according to the present embodiment includes: a storage unit configured to store the unit full charge capacity of each of the plurality of unit cells each time the unit full charge capacity of each of the plurality of unit cells is calculated by the full charge capacity calculation unit; and a statistical value calculation unit configured to calculate a statistical value related to unit full charge capacity on the basis of unit full charge capacities for a predetermined number of times in the past stored in the storage unit, and the update unit updates the full charge capacity of the secondary battery on the basis of a statistical value calculated by the statistical value calculation unit at one time and a statistical value calculated by the statistical value calculation unit at a time previous to the one time.

The storage unit stores the unit full charge capacity of each of the plurality of unit cells each time the unit full charge capacity of each of the plurality of unit cells is calculated by the full charge capacity calculation unit.

The statistical value calculation unit calculates a statistical value related to unit full charge capacity on the basis of the unit full charge capacities for a predetermined number of times in the past stored in the storage unit. The predetermined number of times can be, for example, 5 times, 10 times, or the like from this time (or present time) toward the past, but is not limited to 5 times and 10 times, and may be several times from the viewpoint of reducing errors. The statistical value can be, for example, an average value but is not limited to the average value.

For example, assuming that unit full charge capacities of an arbitrary unit cell are Fn, F(n - 1), F(n - 2), F(n - 3), and F(n - 4) toward the past, the statistical value can be calculated by the formula, {Fn + F(n - 1) + F(n - 2) + F(n - 3) + F(n - 4)}/5.

The update unit updates the full charge capacity of the secondary battery on the basis of a statistical value calculated by the statistical value calculation unit at one time (for example, referred to as this time) and a statistical value calculated by the statistical value calculation unit at a time previous to the one time (for example, referred to as last time).

For example, regarding an arbitrary unit cell, if the statistical value of the unit full charge capacity at this time is greater than the statistical value of the unit full charge capacity at the last time, it is considered that some error has occurred, in view of the fact that the full charge capacity decreases over time, and thus the statistical value at this time is not used. On the other hand, if the statistical value of the unit full charge capacity at this time is equal to or less than the statistical value of the unit full charge capacity at the last time, the full charge capacity of the secondary battery is updated using the statistical value at this time as the unit full charge capacity of the unit cell. Accordingly, an error can be reduced, and the full charge capacity of the secondary battery can be accurately updated.

In the battery monitoring device according to the present embodiment, if the statistical value at the one time is greater than the statistical value at the previous time, the update unit does not update the full charge capacity of the secondary battery.

If the statistical value at the one time is greater than the statistical value at the previous time, the update unit does not update the full charge capacity of the secondary battery. For example, if the statistical value of the unit full charge capacity at this time is greater than the statistical value of the unit full charge capacity at the last time, it is considered that some error has occurred, in view of the fact that the full charge capacity decreases over time, and, thus, the statistical value at this time is not used, and the full charge capacity of the secondary battery is not updated. Accordingly, the accuracy of the full charge capacity of the secondary battery can be prevented from decreasing.

In the battery monitoring device according to the present embodiment, the statistical value calculation unit calculates a statistical value related to unit full charge capacity on the basis of a minimum value, for each of the predetermined number of times in the past, among the respective unit full charge capacities of the plurality of unit cells stored in the storage unit.

The statistical value calculation unit calculates a statistical value related to unit full charge capacity on the basis of a minimum value, for each of the predetermined number of times in the past, among the respective unit full charge capacities of the plurality of unit cells stored in the storage unit.

For example, assuming that, among the respective unit full charge capacities of the plurality of unit cells, the minimum values of the unit full charge capacities are Fn, F(n - 1), F(n - 2), F(n - 3), and F(n - 4) toward the past, the statistical value can be calculated by the formula, {Fn + F(n - 1) + F(n - 2) + F(n - 3) + F(n - 4)}/5. When the respective unit full charge capacities of the plurality of unit cells are different, the full charge capacity of the secondary battery often depends on the minimum value of the unit full charge capacities of the plurality of unit cells. With the above-described configuration, the full charge capacity of the secondary battery in which the plurality of unit cells are connected in series can be accurately obtained.

### [Details of embodiments of the present disclosure]

### (First embodiment)

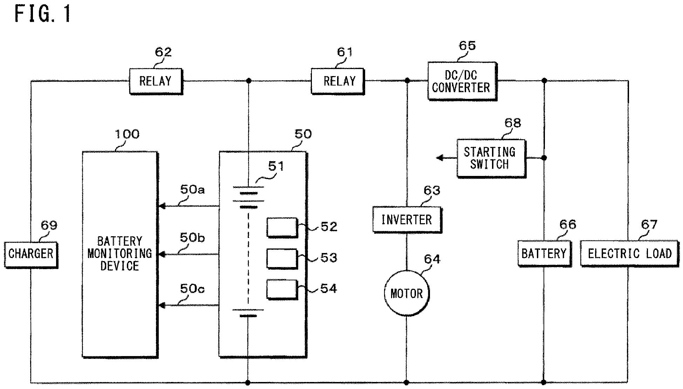

Hereinafter, an embodiment of the battery monitoring device according to the present disclosure will be described with reference to the drawings. FIG. 1 is a block diagram showing an example of the configuration of a main part of a vehicle equipped with a battery monitoring device 100 of the present embodiment. As shown in FIG. 1, in addition to the battery monitoring device 100, the vehicle includes a secondary battery unit 50, relays 61 and 62, an inverter 63, a motor 64, a DC/DC converter 65, a battery 66, an electric load 67, a starting switch 68 as a predetermined switch, a charger 69, etc.

The secondary battery unit (secondary battery) 50 is, for example, a lithium ion battery, and a plurality of cells (unit cells) 51 are connected in series or in series-parallel in the secondary battery unit 50. The secondary battery unit 50 includes a voltage sensor 52, a current sensor 53, and a temperature sensor 54. The voltage sensor 52 detects the voltage of each cell 51 and the voltage between both ends of the secondary battery unit 50, and outputs the detected voltages via a voltage detection line 50a to the battery monitoring device 100. The current sensor 53 is composed of, for example, a shunt resistor, a Hall sensor, or the like and detects the charge current and the discharge current of the secondary battery unit 50. The current sensor 53 outputs the detected currents via a current detection line 50b to the battery monitoring device 100. The temperature sensor 54 is composed of, for example, a thermistor, and detects the temperatures of the cells 51. The temperature sensor 54 outputs the detected temperatures via a temperature detection line 50c to the battery monitoring device 100.

On/Off of the relays 61 and 62 is controlled by a relay control unit that is not shown. The inverter 63 controls current application to the motor 64 on the basis of a command from a vehicle controller that is not shown. The charger 69 receives power from a power supply outside the vehicle and charges the secondary battery unit 50 when the vehicle stops.

The battery 66 is, for example, a lead battery, supplies power to the electric load 67 of the vehicle, and is charged by the secondary battery unit 50 via the DC/DC converter 65 when the relay 61 is turned on. The battery 66 is not limited to the lead battery.

The starting switch 68 is a switch for charging/discharging operation of the secondary battery unit 50, and a signal indicating ON/OFF is outputted therefrom to the battery monitoring device 100. For example, when the starting switch 68 is turned on from an OFF state, if the battery monitoring device 100 is not in operation, the battery monitoring device 100 starts up.

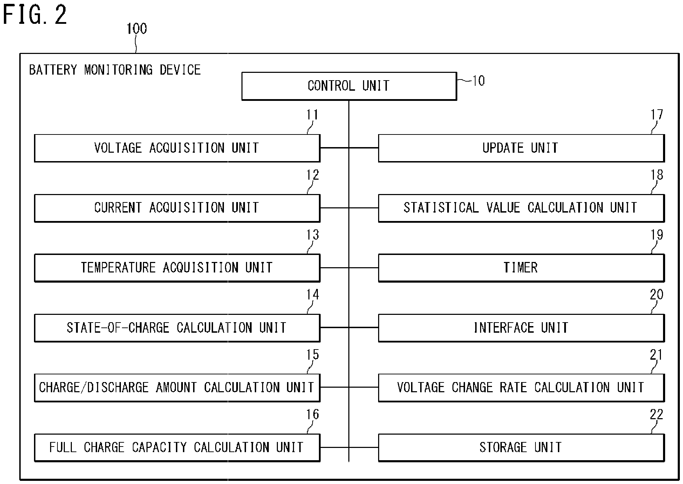

FIG. 2 is a block diagram showing an example of the configuration of the battery monitoring device 100 of the present embodiment. The battery monitoring device 100 includes a control unit 10 that controls the entire device, a voltage acquisition unit 11, a current acquisition unit 12, a temperature acquisition unit 13, a state-of-charge calculation unit 14, a charge/discharge amount calculation unit 15, a full charge capacity calculation unit 16, an update unit 17, a statistical value calculation unit 18, a timer 19, an interface unit 20, a voltage change rate calculation unit 21, a storage unit 22, etc.

The voltage acquisition unit 11 acquires the voltage of each of the plurality of cells 51 and the voltage of the secondary battery unit 50. In addition, the current acquisition unit 12 acquires the current (charge current and discharge current) of the secondary battery unit 50. The control unit 10 can control the sampling cycle for acquiring the voltage and the current. The sampling cycle can be, for example, 10 ms but is not limited thereto. The temperature acquisition unit 13 acquires the temperatures of the cells 51.

The state-of-charge calculation unit 14 calculates the state of charge of each of the plurality of cells 51. The state of charge is also referred to as SOC.

The charge/discharge amount calculation unit 15 calculates the charge/discharge amount of the secondary battery unit 50 on the basis of the current acquired by the current acquisition unit 12. The charge/discharge amount is positive in the case of charging, and is negative in the case of discharging. The charge/discharge amount in a certain period can be positive or negative depending on the magnitudes of the values of the charge current and the discharge current in this period.

The full charge capacity calculation unit 16 calculates the unit full charge amount of each of the plurality of cells 51. In addition, the full charge capacity calculation unit 16 calculates the full charge capacity of the secondary battery unit 50. The method for calculating the full charge capacity will be described in detail later. The full charge capacity calculation unit 16 calculates a full charge capacity and a unit full charge capacity in a predetermined cycle (for example, 1 hour, 30 minutes, or the like). The predetermined cycle is not limited to 30 minutes and 1 hour.

The update unit 17 updates the full charge capacity of the secondary battery unit 50. The conditions for the update will be described in detail later.

The statistical value calculation unit 18 calculates a statistical value of unit full charge capacities calculated in the predetermined cycle a predetermined number of times by the full charge capacity calculation unit 16. The predetermined number of times can be, for example, 5 times, 10 times, or the like, but is not limited to 5 times and 10 times, and may be several times from the viewpoint of reducing errors. The statistical value can be, for example, an average value but is not limited to the average value.

The timer 19 outputs a time measurement result to the control unit 10.

The interface unit 20 acquires an ON/OFF signal of the starting switch 68. In addition, the interface unit 20 has a function as a signal acquisition unit, and acquires a signal related to balancing operation of the remaining capacities of the plurality of cells 51. The balancing operation of the remaining capacities is also referred to as cell balance operation. A circuit (not shown) that performs the balancing operation has, for example, a configuration in which a series circuit of a resistance element and a switch is connected in parallel to each cell 51, and can discharge each cell 51 by turning on the switch, so that the remaining capacities of the plurality of cells 51 can be equalized.

The voltage change rate calculation unit 21 calculates voltage change rates of each of the plurality of cells 51 after the end of charging or discharging of the secondary battery unit 50 and after the time when the starting switch 68 is turned off, respectively, on the basis of the voltage acquired by the voltage acquisition unit 11.

The storage unit 22 stores therein the voltage acquired by the voltage acquisition unit 11, the current acquired by the current acquisition unit 12, the state of charge calculated by the state-of-charge calculation unit 14, the charge/discharge amount calculated by the charge/discharge amount calculation unit 15, the full charge capacity and the unit full charge capacity calculated by the full charge capacity calculation unit 16, the full charge capacity updated by the update unit 17, the statistical value calculated by the statistical value calculation unit 18, etc.

Next, operation of the battery monitoring device 100 of the present embodiment will be described.

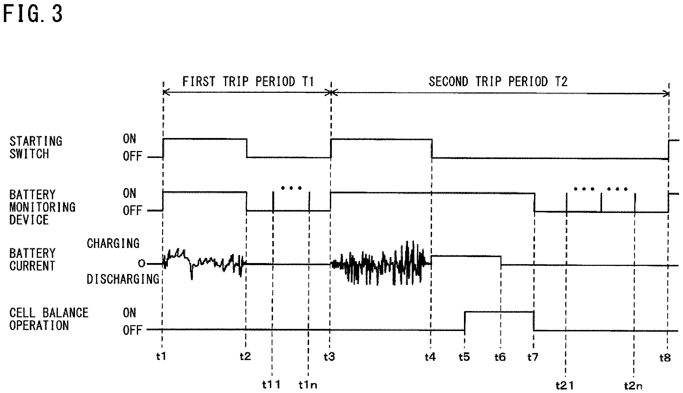

FIG. 3 is a time chart showing an example of operation of the battery monitoring device 100 of the present embodiment. In FIG. 3, from the upper side toward the lower side, the ON/OFF state of the starting switch 68, the operating state (ON/OFF) of the battery monitoring device 100, the charge and discharge state of the secondary battery unit 50, and a cell balance operation state (ON/OFF) are shown.

The starting switch 68 is turned on from an OFF state at time t1 (turn-on time), is turned off from an ON state at time t2 (turn-off time), is turned on from an OFF state at time t3 (turn-on time), is turned off from an ON state at time t4 (turn-off time), and is turned on from an OFF state at time t8 (turn-on time).

The period from the turn-on time (t1) of the starting switch 68 to the next turn-on time (t3) is referred to as a first trip period T1. In addition, the period from the turn-on time (t3) of the starting switch 68 to the next turn-on time (t8) is referred to as a second trip period T2. The second trip period T2 is a trip period next to the first trip period T1.

When the starting switch 68 is turned on at time t1, the battery monitoring device 100 starts operation, and a charge current and a discharge current flows through the secondary battery unit 50 in accordance with running of the vehicle. When the starting switch 68 is turned off at time t2, the vehicle stops, current application to the vehicle from the secondary battery unit 50 stops, and no current flows through the secondary battery unit 50. In addition, operation of the battery monitoring device 100 also stops temporarily.

In the period from time t2 to time t3, that is, when the starting switch 68 is in an OFF state, the battery monitoring device 100 is activated in a predetermined cycle (for example, 30 minutes, 1 hour, or the like) and calculates the unit full charge capacity of each of the plurality of cells 51. Specifically, in the example of FIG. 3, the voltage acquisition unit 11 acquires voltages a plurality of times in the period from time t11 to time tln, and the state-of-charge calculation unit 14 calculates the state of charge of each cell 51. If the time during which the starting switch 68 is in an OFF state is short, the unit full charge capacity is not calculated in some cases.

Moreover, when the starting switch 68 is turned on at time t3, the battery monitoring device 100 starts operation, and a charge current and a discharge current flow through the secondary battery unit 50 in accordance with running of the vehicle. When the starting switch 68 is turned off at time t4, the vehicle stops, and current application to the vehicle from the secondary battery unit 50 stops. In this example, in the period from time t4 to time t6, the secondary battery unit 50 is charged from the external power supply. In addition, at time t5 at which the charging has advanced, cell balance operation is started, and is continued until time t7 even after the charging stops (after time t6). Furthermore, in order to monitor the voltage of each cell 51, the battery monitoring device 100 continues operation until time t7 at which the cell balance operation ends.

In the period from time t7 to time t8, that is, when the starting switch 68 is in an OFF state, the battery monitoring device 100 is activated in a predetermined cycle (for example, 30 minutes, 1 hour, or the like) and calculates the unit full charge capacity of each of the plurality of cells 51. Specifically, in the example of FIG. 3, the voltage acquisition unit 11 acquires voltages a plurality of times in the period from time t21 to time t2n, and the state-of-charge calculation unit 14 calculates the state of charge of each cell 51.

The state-of-charge calculation unit 14 has a function as a first state-of-charge calculation unit, and calculates a first state of charge on the basis of a first voltage acquired by the voltage acquisition unit 11 at a first time at which the starting switch 68 is in an OFF state, in the first trip period T1 (for example, at time t1n in the example of FIG. 3). At times t11, ..., tln, no current flows through the secondary battery unit 50, and thus the first voltage is an open-circuit voltage (OCV).

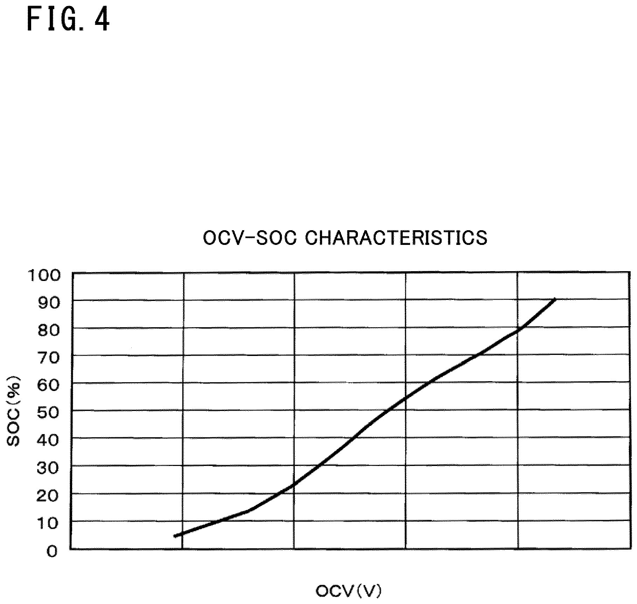

FIG. 4 illustrates an example of a correlation between the open-circuit voltage and the state of charge of the cell 51 of the present embodiment. In FIG. 4, the horizontal axis indicates open-circuit voltage (OCV), and the vertical axis indicates state of charge (SOC). As shown in FIG. 4, the state of charge increases as the open-circuit voltage of the cell 51 increases. The correlation between the open-circuit voltage and the state of charge illustrated in FIG. 4 may be stored in the storage unit 22, or may be calculated by a calculation circuit.

The state-of-charge calculation unit 14 can calculate the first state of charge on the basis of the first voltage by using the correlation shown in FIG. 4.

The state-of-charge calculation unit 14 has a function as a second state-of-charge calculation unit, and calculates a second state of charge on the basis of a second voltage acquired by the voltage acquisition unit 11 at a second time at which the starting switch 68 is in an OFF state, in the second trip period T2 (for example, at times t21, ..., t2n in the example of FIG. 3). At time t2n, no current flows through the secondary battery unit 50, and thus the second voltage is an open-circuit voltage (OCV). Hereinafter, the first time is defined as time tln, the second time is defined as time t2n, the first state of charge is represented as SOC1, and the second state of charge is represented as SOC2.

The charge/discharge amount calculation unit 15 calculates the charge/discharge amount of the secondary battery unit 50 on the basis of the charge/discharge current acquired by the current acquisition unit 12 in the period from first time t1n to second time t2n. The charge/discharge amount from first time t1n to second time t2n is represented as ΔC.

The full charge capacity calculation unit 16 calculates the unit full charge capacity of each of the plurality of cells 51 on the basis of the first state of charge SOC1, the second state of charge SOC2, and the charge/discharge amount ΔC.When the unit full charge capacity is represented as F, the unit full charge capacity F can be calculated by the formula, F = ΔC/ΔSOC (where ΔSOC = SOC2 - SOC1).

The update unit 17 updates the full charge capacity of the secondary battery unit 50 on the basis of the unit full charge capacity calculated by the full charge capacity calculation unit 16, when a predetermined condition is satisfied. For example, the full charge capacity of the secondary battery unit 50 can be calculated by summing up the unit full charge capacities of the respective unit cells.

As described above, the voltage of each cell 51 at a time at which the starting switch 68 is in an OFF state is acquired, and thus no charge/discharge current flows through each cell 51. Therefore, an accurate open-circuit voltage (OCV) of each cell 51 can be obtained. As a result, the full charge capacity of the secondary battery unit 50 can be accurately calculated.

Assuming that the internal resistance of a cell is 5 mΩ and the current flowing through the cell immediately after the starting switch is turned on is 5 A, the voltage of the cell has an error of 25 mV (difference from an accurate open-circuit voltage). If there is an error of 25 mV in the open-circuit voltage, an error of about 10% occurs in the SOC. According to the present embodiment, as described above, no current flows through the cell 51, and thus an accurate open-circuit voltage can be obtained and an SOC can be accurately calculated.

As the timing for acquiring the voltage of each cell 51, for example, the following condition can be used.

The voltage acquisition unit 11 acquires the first voltage and the second voltage except the voltage acquired during charging or discharging of the secondary battery unit 50. In other words, the voltage acquisition unit 11 acquires no voltage during charging or discharging of the secondary battery unit 50. In the example of FIG. 3, in the period from time t1 to time t2 and in the period from time t3 to time t6, the secondary battery unit 50 is being charged or discharged, and thus the voltage acquired by the voltage acquisition unit 11 is not used for calculating a state of charge. Accordingly, the voltage (that is, the open-circuit voltage) when no current flows through the secondary battery unit 50 (cells 51) can be acquired, and a state of charge (SOC) can be accurately calculated.

Moreover, the voltage acquisition unit 11 acquires the first voltage and the second voltage except the voltage acquired within a predetermined period from the end of charging or discharging of the secondary battery unit 50 or within a predetermined period from a turn-off time of the starting switch 68.

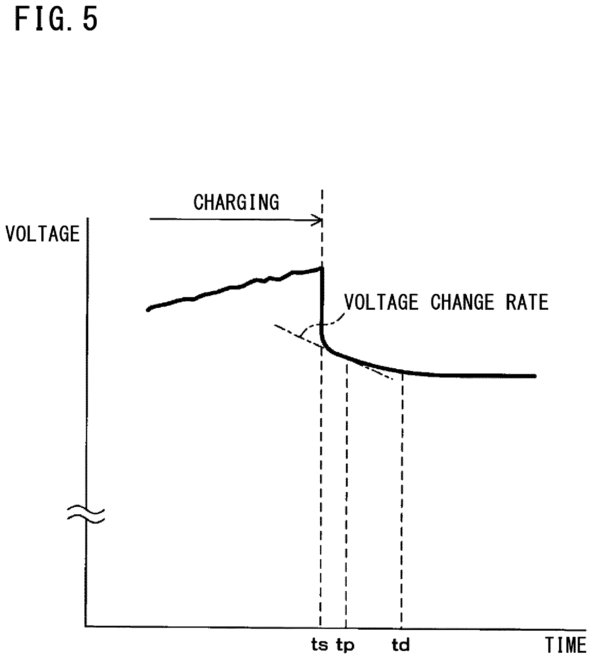

FIG. 5 is a schematic diagram showing an example of a change in voltage of the cell 51 after the end of charging. In FIG. 5, the horizontal axis indicates time, and the vertical axis indicates voltage. During charging before time ts, the voltage of the cell 51 tends to gradually increase (the voltage is maintained at a constant value after the cell 51 becomes fully charged). When charging is stopped at time ts, the voltage of the cell 51 tends to decrease once, then gradually decrease, and transition at a substantially constant value after time td.

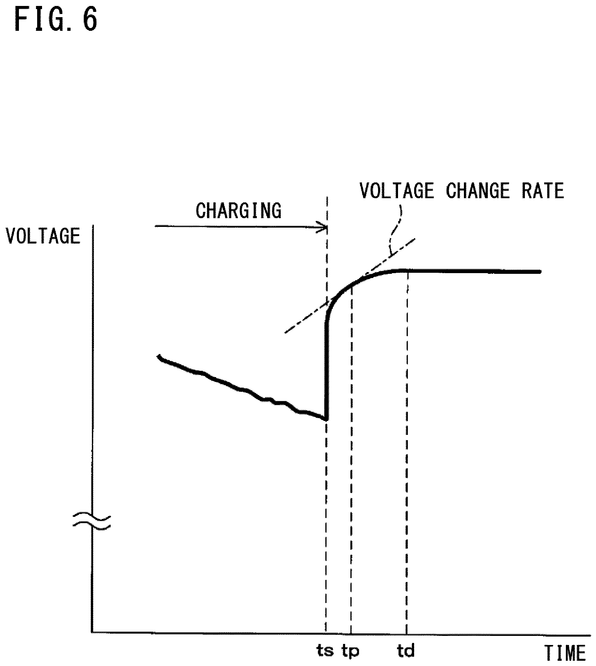

FIG. 6 is a schematic diagram showing an example of a change in voltage of the cell 51 after the end of discharging. In FIG. 6, the horizontal axis indicates time, and the vertical axis indicates voltage. During discharging before time ts, the voltage of the cell 51 tends to gradually decrease. When discharging is stopped at time ts, the voltage of the cell 51 tends to greatly increase once, then gradually increase, and transition at a substantially constant value after time td.

As shown in FIG. 5 and FIG. 6, there is a possibility that the voltage of the cell 51 is not stable within a predetermined period after the end of charging or after the end of discharging (for example, in the period from time ts to time td illustrated in FIG. 5 and FIG. 6) or within a predetermined period after the starting switch 68 is turned off (in the example of FIG. 3, within a predetermined period after time t2). Therefore, by acquiring a voltage after the voltage of the cell 51 is stabilized, a state of charge (SOC) can be accurately calculated.

Moreover, the voltage acquisition unit 11 acquires the first voltage and the second voltage except the voltage acquired when the voltage change rate calculated by the voltage change rate calculation unit 21 is equal to or greater than a predetermined value. In the example of FIG. 5, the voltage change rate of the cell 51 at time tp is relatively high, and the voltage of the cell 51 is not stable. In addition, in the example of FIG. 6, the voltage change rate of the cell 51 at time tp is relatively high, and the voltage of the cell 51 is not stable. That is, after the end of charging, after the end of discharging, or after the starting switch 68 is turned off, there is a possibility that the voltage of the cell 51 is not stable, and thus, by acquiring the voltages after the voltage of the cell 51 is stabilized, a state of charge (SOC) can be accurately calculated.

Moreover, the voltage acquisition unit 11 acquires the first voltage and the second voltage except the voltage acquired when the signal acquired by the interface unit 20 indicates that cell balance operation is being performed. In the example of FIG. 3, in the period from time t5 to time t7, the cell balance operation is performed. During the cell balance operation, there is a possibility that the voltage of the cell 51 is not stable, and thus the voltages are acquired when cell balance operation is not performed. In the example of FIG. 3, the voltage of each cell 51 is acquired in the period from time t7 to time t8 during which charging/discharging of secondary battery unit 50 is not performed and cell balance operation is not performed. Accordingly, a state of charge (SOC) can be accurately calculated.

Next, the method for updating the full charge capacity of the secondary battery unit 50 will be described.

The update unit 17 updates the full charge capacity of the secondary battery unit 50 on the basis of a unit full charge capacity calculated by the full charge capacity calculation unit 16 at one time (for example, referred to as this time) and a unit full charge capacity calculated by the full charge capacity calculation unit 16 at a time previous to the one time (for example, referred to as last time).

In the example of FIG. 3, the unit full charge capacity at this time can be calculated by the formula, F = ΔC/ΔSOC (where ΔSOC = SOC2 - SOC1). Here, ΔC is the charge/discharge amount from time t1n to time t2n, SOC2 is the state of charge at time t2n, and SOC1 is the state of charge at time t1n.

In addition, the unit full charge capacity at the last time can be calculated by the formula, F = ΔC/ΔSOC (where ΔSOC = SOC2 - SOC1). Here, ΔC is the charge/discharge amount from time t1n to time t2(n - 1), SOC2 is the state of charge at time t2(n - 1), and SOC1 is the state of charge at time t1n. Time t2(n - 1) is a time in the past that is previous to time t2n by a predetermined cycle (for example, 30 minutes, 1 hour, or the like).

For example, regarding an arbitrary cell 51, if the unit full charge capacity at this time is greater than the unit full charge capacity at the last time, it is considered that some error has occurred, in view of the fact that the full charge capacity decreases over time, and, thus, the unit full charge capacity at this time (time t2n) is not used, and the unit full charge capacity at the last time (time t2(n - 1)) is used. On the other hand, if the unit full charge capacity at this time is equal to or less than the unit full charge capacity at the last time, the full charge capacity of the cell 51 is updated with the full charge capacity at this time. Accordingly, the unit full charge capacity of the cell 51 can be accurately updated.

When updating the unit full charge capacity of the cell 51, a statistical value of the unit full charge capacity can be used. Hereinafter, the case of using a statistical value will be described.

Each time the unit full charge capacity of each cell 51 is calculated by the full charge capacity calculation unit 16, the calculated unit full charge capacity is stored in the storage unit 22. For example, in FIG. 3, the unit full charge capacity of each cell 51 calculated at each of times t21, ..., t2n can be stored so as to be associated with identification information (ID) of the cell 51.

The statistical value calculation unit 18 calculates a statistical value related to unit full charge capacity for each cell 51 on the basis of the unit full charge capacities for a predetermined number of times in the past stored in the storage unit 22. The predetermined number of times can be, for example, 5 times, 10 times, or the like from this time (or present time) toward the past, but is not limited to 5 times and 10 times, and may be several times from the viewpoint of reducing errors. The statistical value can be, for example, an average value but is not limited to the average value.

For example, assuming that unit full charge capacities of an arbitrary cell 51 are Fn, F(n - 1), F(n - 2), F(n - 3), and F(n - 4) toward the past, the statistical value can be calculated by the formula, {Fn + F(n - 1) + F(n - 2) + F(n - 3) + F(n - 4)}/5.

For example, in FIG. 3, assuming that the unit full charge capacity immediately before time t8 is Fn, the full charge capacity calculation unit 16 calculates the unit full charge capacity of the cell 51 at each of times t21, ..., t2n as described above, but which of the said times is t8 is not known, and thus the unit full charge capacity is calculated at each time, update is performed at each time of calculation, and the value immediately before t8 (for example, time t2n) becomes Fn. In this case, the values from time t21 to time t2(n - 1) are discarded. In addition, as F(n - 1), a value calculated before time t1 is used, although not shown in the example of FIG. 3. Then, the update unit 17 updates the full charge capacity of the secondary battery unit 50 on the basis of a statistical value calculated by the statistical value calculation unit 18 at one time (for example, referred to as this time) and a statistical value calculated by the statistical value calculation unit 18 at a time previous to the one time (for example, referred to as last time).

Regarding an arbitrary cell 51, if the statistical value of the unit full charge capacity at this time is greater than the statistical value of the unit full charge capacity at the last time, it is considered that some error has occurred, in view of the fact that the full charge capacity decreases over time, and thus the statistical value at this time is not used. On the other hand, if the statistical value of the unit full charge capacity at this time is equal to or less than the statistical value of the unit full charge capacity at the last time, the full charge capacity of the secondary battery unit 50 is updated using the statistical value at this time as the full charge capacity of the cell 51. Accordingly, an error can be reduced, and the full charge capacity of the secondary battery unit 50 can be accurately updated.

Moreover, the statistical value calculation unit 18 can calculate a statistical value related to unit full charge capacity on the basis of the minimum value, for each of a predetermined number of times in the past, among the respective unit full charge capacities of the plurality of cells 51 stored in the storage unit 22.

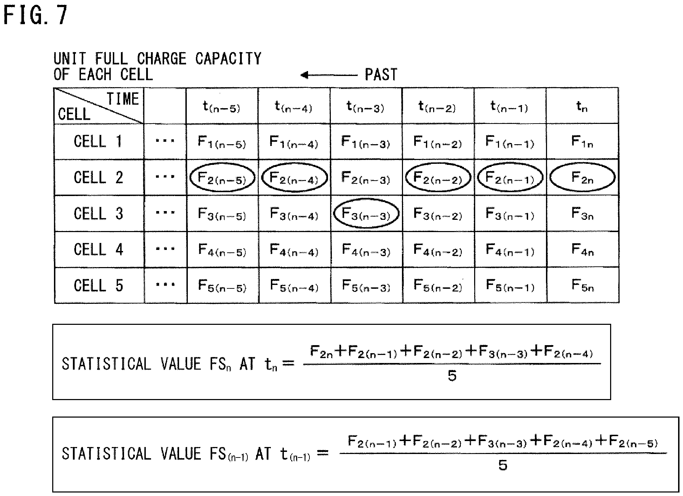

FIG. 7 illustrates an example of a history of the unit full charge capacity of each cell 51. In the example of FIG. 7, for convenience, it is assumed that the secondary battery unit 50 is composed of five cells 51 including cells 1 to 5. In FIG. 7, the unit full charge capacity of each cell 51 calculated and stored at each time is shown in the order of times tn, t(n - 1), t(n - 2), t(n - 3), t(n - 4), t(n - 5), ... toward the past. For example, the unit full charge capacities of the cells 1 to 5 are represented as F1n, F2n, F3n, F4n, and F5n at time tn, and the unit full charge capacities of the cells 1 to 5 are represented as F1(n - 1), F2(n - 1), F3(n - 1), F4(n - 1), and F5(n - 1) at time t(n - 1). The same applies to the other times. In addition, in FIG. 7, circled values indicate minimum values. For example, it is indicated that, among the unit full charge capacities F1n, F2n, F3n, F4n, and F5n of the cells 1 to 5 at time tn, F2n is the minimum value. The same applies to the other times.

In the case of FIG. 7, the statistical value calculation unit 18 calculates a statistical value FSn at time tn by the formula, FSn = {F2n + F2(n - 1) + F2(n - 2) + F3(n - 3) + F2(n - 4)}/5. In addition, the statistical value calculation unit 18 calculates a statistical value FS(n - 1) at time t(n - 1) by the formula, FS(n - 1) = {F2(n - 1) + F2(n - 2) + F3(n - 3) + F2(n - 4) + F2(n - 5)}/5.

When the respective unit full charge capacities of the plurality of cells 51 are different, the full charge capacity of the secondary battery unit 50 often depends on the minimum value of the unit full charge capacities of the plurality of cells 51. With the above-described configuration, the full charge capacity of the secondary battery unit 50 in which the plurality of cells 51 are connected in series can be accurately obtained.

Next, the method for updating the full charge capacity of the secondary battery unit 50 will be described.

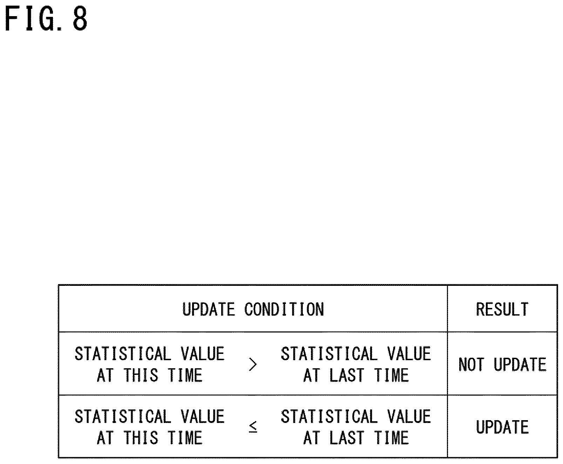

FIG. 8 illustrates a first example of the method for updating the secondary battery unit 50 by the battery monitoring device 100 of the present embodiment. As shown in FIG. 8, if the statistical value at this time is greater than the statistical value at the last time, the update unit 17 does not update the full charge capacity of the secondary battery unit 50. For example, if the statistical value of the unit full charge capacity at this time is greater than the statistical value of the unit full charge capacity at the last time, it is considered that some error has occurred, in view of the fact that the unit full charge capacity (full charge capacity) decreases over time, and, thus, the statistical value at this time is not used, and the full charge capacity of the secondary battery unit 50 is not updated. Accordingly, the accuracy of the full charge capacity of the secondary battery unit 50 can be prevented from decreasing.

Moreover, as shown in FIG. 8, if the statistical value at this time is equal to or less than the statistical value at the last time, the update unit 17 updates the full charge capacity of the secondary battery unit 50 on the basis of the statistical value at this time. For example, if the statistical value of the unit full charge capacity at this time is equal to or less than the statistical value of the unit full charge capacity at the last time, since the full charge capacity of the secondary battery unit 50 is updated, the full charge capacity that decreases over time can be reflected and the full charge capacity of the secondary battery unit 50 can be accurately obtained.

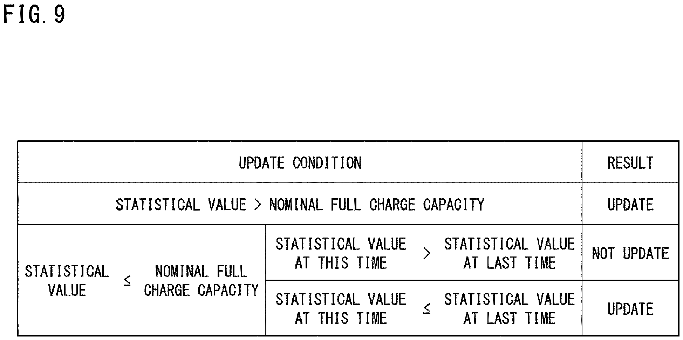

FIG. 9 illustrates a second example of the method for updating the secondary battery unit 50 by the battery monitoring device 100 of the present embodiment. As shown in FIG. 9, if the statistical value at an arbitrary time is greater than the nominal full charge capacity, the update unit 17 updates the full charge capacity of the secondary battery unit 50 on the basis of the statistical value at this time.

The actual full charge capacity (actual value) of a battery is generally greater than the nominal full charge capacity thereof in consideration of variations in battery production and the like. In particular, when the cell 51 (or the secondary battery unit 50) is new or nearly new, the unit full charge capacity of the cell 51 is often greater than the nominal full charge capacity thereof. Therefore, if the statistical value is greater than the nominal full charge capacity, the full charge capacity of the secondary battery unit 50 is updated on the basis of the statistical value.

For example, assuming that the nominal full charge capacity is FN and the calculated full charge capacity of the secondary battery unit 50 is F (= FN + ΔF), by setting the full charge capacity of the secondary battery unit 50 to F and not to FN, it is made possible to perform regeneration by the capacity corresponding to ΔF, so that the range where regeneration is possible can be expanded.

Moreover, as shown in FIG. 9, if the statistical value at this time is equal to or less than the nominal full charge capacity and greater than the statistical value at the last time, the update unit 17 does not update the full charge capacity of the secondary battery unit 50. If the statistical value is equal to or less than the nominal full charge capacity, there is no room to expand the range where regeneration is possible, as when the statistical value is greater than the nominal full charge capacity. Furthermore, if the statistical value of the unit full charge capacity at this time is greater than the statistical value of the unit full charge capacity at the last time, it is considered that some error has occurred, and, thus, the statistical value at this time is not used, and the full charge capacity of the secondary battery unit 50 is not updated. Accordingly, the accuracy of the full charge capacity of the secondary battery unit 50 can be prevented from decreasing.

Moreover, as shown in FIG. 9, if the statistical value at this time is equal to or less than the nominal full charge capacity and equal to or less than the statistical value at the last time, the update unit 17 updates the full charge capacity of the secondary battery unit 50 on the basis of the statistical value. If the statistical value is equal to or less than the nominal full charge capacity, there is no room to expand the range where regeneration is possible, as when the statistical value is greater than the nominal full charge capacity. Furthermore, if the statistical value of the unit full charge capacity at this time is equal to or less than the statistical value of the unit full charge capacity at the last time, since the full charge capacity of the secondary battery unit 50 is updated, the full charge capacity that decreases over time can be reflected and the full charge capacity of the secondary battery unit 50 can be accurately obtained.

Moreover, by grasping the initial full charge capacity of the secondary battery unit 50 and comparing the initial full charge capacity with the nominal full charge capacity, the degree of deterioration of the secondary battery unit 50 can also be accurately grasped.

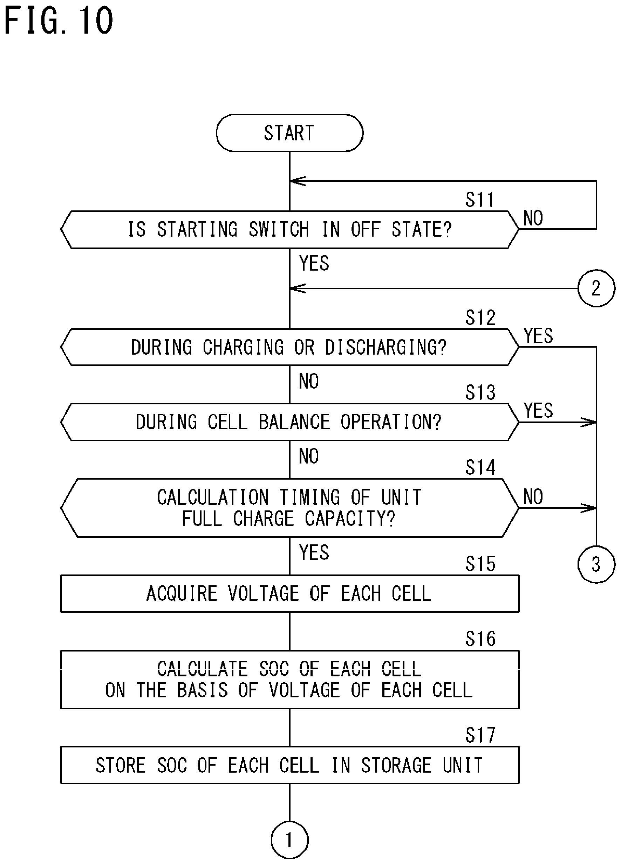

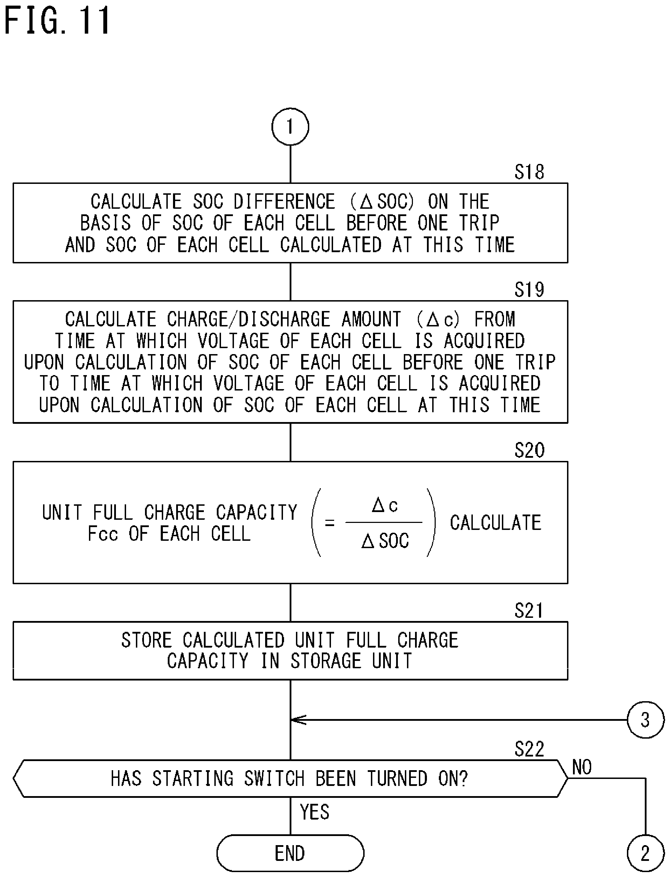

FIG. 10 and FIG. 11 are flowcharts showing an example of a process procedure for calculating a unit full charge capacity by the battery monitoring device 100 of the present embodiment. Hereinafter, for convenience, a description will be given with the control unit 10 as the subject of the process. The control unit 10 determines whether the starting switch 68 is in an OFF state (S11). If the starting switch 68 is not in an OFF state (NO in S11), the control unit 10 continues the process in step S11. If the starting switch 68 is in an OFF state, operation of the battery monitoring device 100 is stopped, but the battery monitoring device 100 can constantly monitor the ON/OFF state of the starting switch 68 in a power saving mode or standby state.

If the starting switch 68 is in an OFF state (YES in S11), the control unit 10 determines whether charging or discharging is being performed (S12). If charging or discharging is not being performed (NO in S12), the control unit 10 determines whether cell balance operation is being performed (S13).

If cell balance operation is not being performed (NO in S13), the control unit 10 determines whether it is a calculation timing of the unit full charge capacity of each cell 51 (S14). The calculation timing can be determined, for example, on the basis of whether a time corresponding to a predetermined cycle (for example, 30 minutes, 1 hour, or the like) has elapsed from the time of calculation at the last time.

If it is the calculation timing of the unit full charge capacity (YES in S14), the control unit 10 acquires the voltage of each cell 51 (S15), calculates the SOC of each cell 51 on the basis of the voltage of each cell 51 (S16), and stores the calculated SOC of each cell 51 in the storage unit 22 (S17).

The control unit 10 calculates an SOC difference (ΔSOC) on the basis of the SOC of each cell 51 before one trip and the SOC of each cell 51 calculated at this time (S18). The control unit 10 calculates a charge/discharge amount (ΔC) from the time at which the voltage of each cell 51 is acquired upon calculation of the SOC of each cell 51 before the one trip to the time at which the voltage of each cell 51 is acquired upon calculation of the SOC of each cell 51 at this time (S19).

The control unit 10 calculates a unit full charge capacity FCC of each cell 51 by the formula FCC = ΔC/ΔSOC (S20) and stores the calculated unit full charge capacity in the storage unit 22 (S21). The control unit 10 determines whether the starting switch 68 has been turned on (S22). If the starting switch 68 has not been turned on (NO in S22), the control unit 10 continues the processes in step S12 and the subsequent steps.

If charging or discharging is being performed (YES in S12), if cell balance operation is being performed (YES in S13), or if it is not the calculation timing of the unit full charge capacity (NO in S14), the control unit 10 performs the process in step S22. If the starting switch 68 has been turned on (YES in S22), the control unit 10 ends the process.

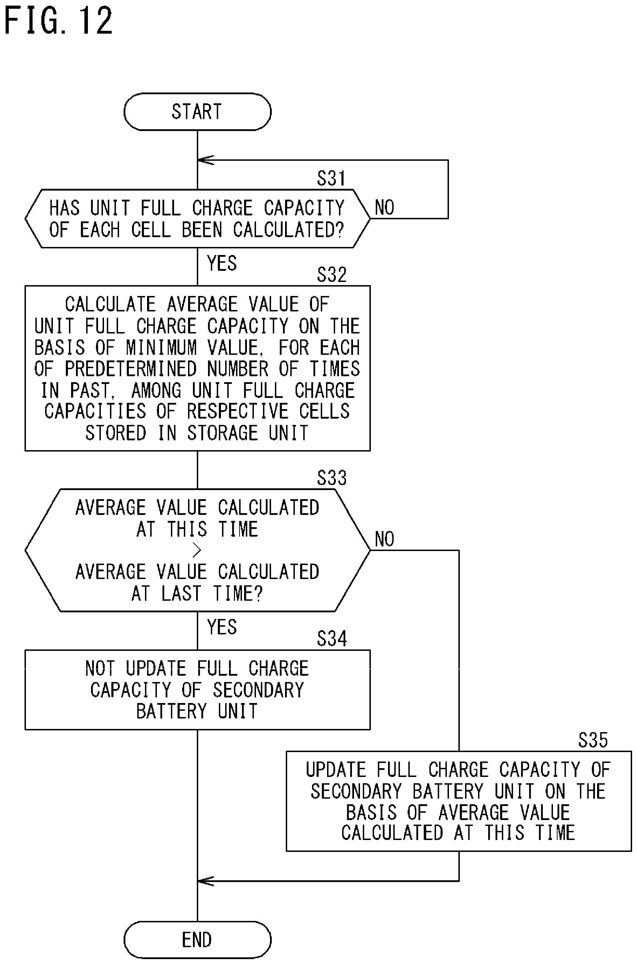

FIG. 12 is a flowchart showing an example of a process of updating the full charge capacity by the battery monitoring device 100 of the present embodiment. The control unit 10 determines whether the unit full charge capacity of each cell 51 has been calculated (S31). If the unit full charge capacity has not been calculated (NO in S31), the control unit 10 continues the process in step S31.

If the unit full charge capacity has been calculated (YES in S31), the control unit 10 calculates the average value of the unit full charge capacity on the basis of the minimum value, for each of a predetermined number of times in the past, among the unit full charge capacities of the respective cells 51 stored in the storage unit 22 (S32).

The control unit 10 determines whether the average value calculated at this time is greater than the average value calculated at the last time (S33). If the average value calculated at this time is greater than the average value calculated at the last time (YES in S33), the control unit 10 does not update the full charge capacity of the secondary battery unit 50 (S34) and ends the process.

If the average value calculated at this time is not greater than the average value calculated at the last time (NO in S33), the control unit 10 updates the full charge capacity of the secondary battery unit 50 on the basis of the average value calculated at this time (S35) and ends the process.

The battery monitoring device 100 of the present embodiment can also be realized by using a general purpose computer including a CPU (processor), a RAM (memory), etc. That is, the battery monitoring device 100 can be realized on the computer by loading a computer program defining the process procedures as shown in FIG. 10 to FIG. 12 onto the RAM (memory) included in the computer, and executing the computer program by the CPU (processor).

### (Second embodiment)

In a second embodiment, the contents of FIG. 1 of the first embodiment are used. As shown in FIG. 1, in addition to the battery monitoring device 100, the vehicle includes a secondary battery unit 50, relays 61 and 62, an inverter 63, a motor 64, a DC/DC converter 65, a battery 66, an electric load 67, a starting switch 68, a charger 69, etc. The starting switch 68 is a switch for turning on the power before running the vehicle.

The secondary battery unit (secondary battery) 50 is, for example, a lithium ion battery, and a plurality of cells (unit cells) 51 are connected in series or in series-parallel in the secondary battery unit 50. The secondary battery unit 50 includes a voltage sensor 52, a current sensor 53, and a temperature sensor 54. The voltage sensor 52 detects the voltage of each cell 51 and the voltage between both ends of the secondary battery unit 50, and outputs the detected voltages via a voltage detection line 50a to the battery monitoring device 100. The current sensor 53 is composed of, for example, a shunt resistor, a Hall sensor, or the like and detects the charge current and the discharge current of the secondary battery unit 50. The current sensor 53 outputs the detected currents via a current detection line 50b to the battery monitoring device 100. The temperature sensor 54 is composed of, for example, a thermistor, and detects the temperatures of the cells 51. The temperature sensor 54 outputs the detected temperatures via a temperature detection line 50c to the battery monitoring device 100.

On/Off of the relays 61 and 62 is controlled by a relay control unit that is not shown. The inverter 63 controls current application to the motor 64 on the basis of a command from a vehicle controller that is not shown. The charger 69 receives power from a power supply outside the vehicle and charges the secondary battery unit 50 when the vehicle stops.

The battery 66 is, for example, a lead battery, supplies power to the electric load 67 of the vehicle, and is charged by the secondary battery unit 50 via the DC/DC converter 65 when the relay 61 is turned on. The battery 66 is not limited to the lead battery.

The starting switch 68 is a switch for charging/discharging operation of the secondary battery unit 50, and a signal indicating ON/OFF is outputted therefrom to the battery monitoring device 100. For example, when the starting switch 68 is turned on from an OFF state, if the battery monitoring device 100 is not in operation, the battery monitoring device 100 starts up. If the starting switch 68 is in an OFF state, operation of the battery monitoring device 100 is stopped, but the battery monitoring device 100 can constantly monitor the ON/OFF state of the starting switch 68 in a power saving mode or standby state.

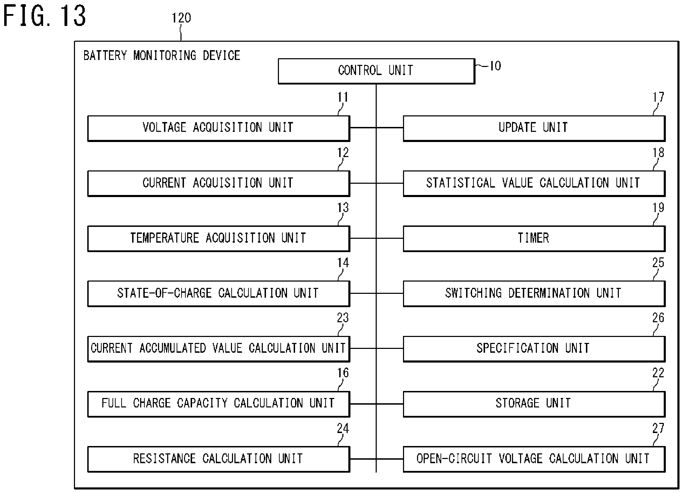

FIG. 13 is a block diagram showing an example of the configuration of a battery monitoring device 120 of the present embodiment. The battery monitoring device 120 includes a control unit 10 that controls the entire device, a voltage acquisition unit 11, a current acquisition unit 12, a temperature acquisition unit 13, a state-of-charge calculation unit 14, a current accumulated value calculation unit 23, a full charge capacity calculation unit 16, a resistance calculation unit 24, an update unit 17, a statistical value calculation unit 18, a timer 19, a switching determination unit 25, a specification unit 26, a storage unit 22, an open-circuit voltage calculation unit 27, etc.

The voltage acquisition unit 11 acquires the voltage of each of the plurality of cells 51 and the voltage of the secondary battery unit 50. In addition, the current acquisition unit 12 acquires the current (charge current and discharge current) of the secondary battery unit 50. The control unit 10 can control the sampling cycle for acquiring the voltage and the current. The sampling cycle can be, for example, 10 ms but is not limited thereto. The temperature acquisition unit 13 acquires the temperatures of the cells 51.

The current accumulated value calculation unit 23 calculates a current accumulated value of the secondary battery unit 50 (each cell 51) on the basis of the current acquired by the current acquisition unit 12. Assuming that the charge current of the secondary battery unit 50 is positive and the discharge current of the secondary battery unit 50 is negative, the current accumulated value increases during charging, and decreases during discharging. The current accumulated value in a certain period can be positive or negative compared to that at the start of this period, depending on the magnitudes of the charge current and the discharge current in this period.

The full charge capacity calculation unit 16 calculates the unit full charge amount of each of the plurality of cells 51 in a certain period. In addition, the full charge capacity calculation unit 16 calculates the full charge capacity of the secondary battery unit 50 in a certain period. The method for calculating the full charge capacity will be described in detail later.

The update unit 17 updates the full charge capacity of the secondary battery unit 50. The conditions for the update will be described in detail later.

The statistical value calculation unit 18 calculates a statistical value of unit full charge capacities calculated a predetermined number of times by the full charge capacity calculation unit 16. The predetermined number of times can be, for example, 5 times, 10 times, or the like, but is not limited to 5 times and 10 times, and may be several times from the viewpoint of reducing errors. The statistical value can be, for example, an average value but is not limited to the average value.

The timer 19 outputs a time measurement result to the control unit 10.

The switching determination unit 25 determines presence/absence of switching between charging and discharging of the secondary battery unit 50 on the basis of the current acquired by the current acquisition unit 12. For example, the current at one of charging or discharging is defined as positive in advance, and, if the current changes from positive to negative or 0, if the current changes from 0 to positive or negative, or if the current changes from negative to positive or 0, it can be determined that switching between charging and discharging has occurred.

The resistance calculation unit 24 calculates the internal resistance of each of the plurality of cells 51. Next, the method for calculating the internal resistance of the cell 51 will be described.

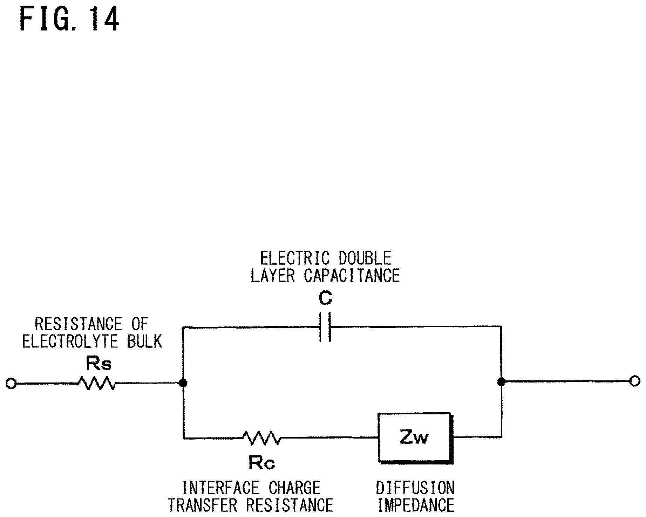

FIG. 14 illustrates an example of an equivalent circuit of the cell 51 of the present embodiment. The cell 51 can be represented by an equivalent circuit composed of a resistance Rs of an electrolyte bulk, an interface charge transfer resistance Rc, an electric double layer capacitance C, and a diffusion impedance Zw. More specifically, the impedance of the cell 51 can be equivalently represented by a circuit in which the resistance Rs of the electrolyte bulk is further connected in series to a circuit in which the electric double layer capacitance C is connected in parallel to a series circuit of the interface charge transfer resistance Rc and the diffusion impedance Zw.

The resistance Rs of the electrolyte bulk includes the conduction resistance of lithium (Li) ions in an electrolyte, the electron resistance at positive and negative electrodes, etc. The interface charge transfer resistance Rc includes the charge transfer resistance and the film resistance on an active material surface, etc. The diffusion impedance Zw is an impedance resulting from a diffusion process of lithium (Li) ions into active material particles.

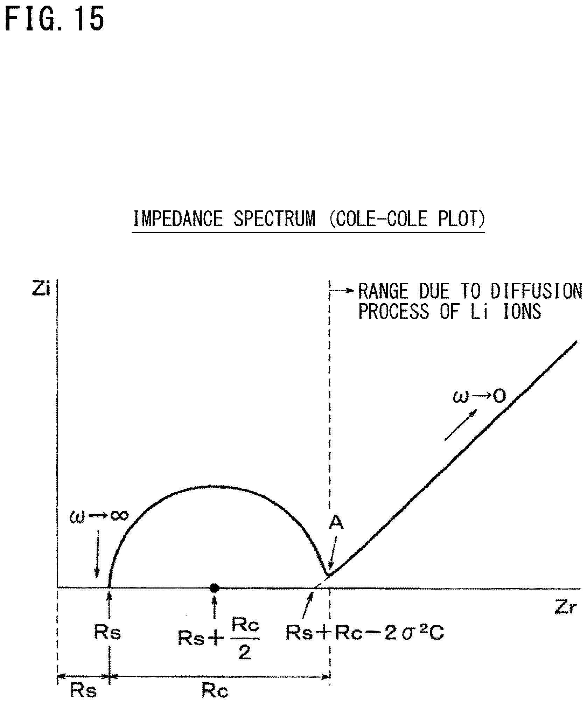

FIG. 15 illustrates an example of an impedance spectrum of the cell 51 of the present embodiment. In FIG. 15, the horizontal axis indicates the real number component Zr of an impedance Z, and the vertical axis indicates the imaginary number component Zi of the impedance Z. The internal resistance of the cell 51 is mainly composed of the resistance Rs of the electrolyte bulk and the interface charge transfer resistance Rc. Meanwhile, when the frequency in the AC impedance method is changed from a high frequency to a low frequency (for example, from 100 kHz to 0.01 mHz, or from 1 MHz to 10 µHz), as shown in FIG. 15, in a certain frequency range (referred to as boundary frequency range: around an area indicated by character A in FIG. 15), the diffusion impedance Zw increases and the impedance of the cell 51 increases (contributes to the impedance of the cell 51).

That is, in the impedance spectrum of the cell 51, the fact that the diffusion impedance resulting from the diffusion process of predetermined ions contributes to the impedance of the cell 51 means that, when the frequency (or angular frequency) decreases from a high frequency toward a low frequency, the diffusion impedance Zw increases and the impedance of the cell 51 increases. In other words, the boundary frequency range means a frequency range in which the impedance of the cell 51 can be represented by the total value of the resistance Rs of the electrolyte bulk and the interface charge transfer resistance Rc, and the influence (contribution) by the diffusion impedance Zw is small or negligible.

In FIG. 15, when w = ∞, the impedance Z at the point where the trajectory intersects the horizontal axis is Z = Zr = Rs. The impedance Z at the center of the semicircular trajectory (the point that intersects the horizontal axis) is Z = Zr = Rs + Rc/2. In addition, it can be seen that, in Fig. 15, when w becomes smaller than the boundary frequency range indicated by character A, the trajectory of impedance Z increases linearly. The impedance Z at the point where an extension of such a straight line intersects the horizontal axis is Z = Zr = Rs + R - 2σ²C. A frequency range smaller than the boundary frequency range indicated by character A is a range due to the diffusion process of lithium ions, and the diffusion impedance Zw increases as the frequency decreases.

As described above, the internal resistance R of the cell 51 is mainly composed of the resistance Rs of the electrolyte bulk and the interface charge transfer resistance Rc. In addition, when the frequency in the AC impedance method is changed from a high frequency to a low frequency, the diffusion impedance Zw increases in the boundary frequency range, and the impedance of the cell 51 increases. Therefore, it can be considered that the impedance Z in the boundary frequency range before the diffusion impedance Zw increases represents the internal resistance R of the cell 51.

Moreover, the frequency f in the AC impedance method and a standby time T from application of a direct current to measurement have a relationship of T = 1/(2 × f). That is, the standby time T can be specified from, for example, the relationship of the reciprocal of twice the frequency f. For example, when the frequency f is 5 Hz, the standby time T is 0.1 second. Setting the standby time T to the reciprocal of twice the frequency f is an example, and, for example, the standby time T may be set to the reciprocal of four times the frequency f.

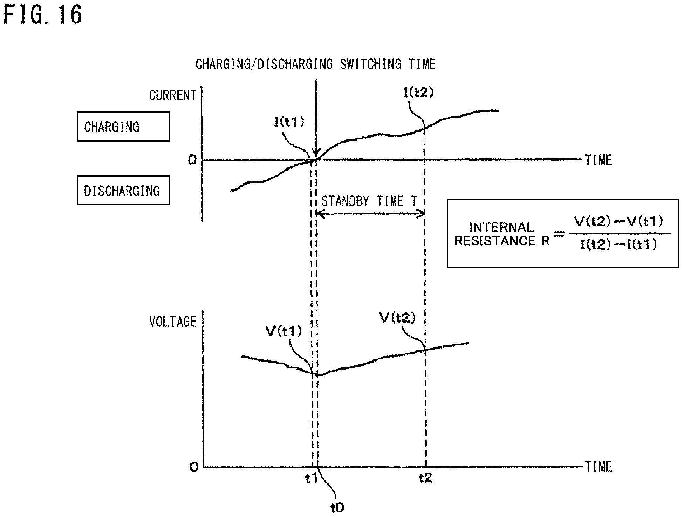

FIG. 16 illustrates an example of a state of change in current and voltage of the cell 51 of the present embodiment before and after switching between charging and discharging. In the example of FIG. 16, at time t0, switching is made from discharging to charging. The current and the voltage of the cell 51 immediately before time t0 of switching between charging and discharging (at time t1 in the example of FIG. 16) are denoted by I(t1) and V(t1), respectively, and the current and the voltage of the cell 51 at a time at which the standby time T elapses from the switching time (time t2 in the example of FIG. 16) are denoted by I(t2) and V(t2), respectively. The resistance calculation unit 24 can calculate the internal resistance R of the cell 51 by the formula R = {V(t2) - V(t1)}/{I(t2) - I(t1)}. The same applies to the case of switching from charging to discharging.

Accordingly, the internal resistance R of the cell 51 can be accurately calculated.

The open-circuit voltage calculation unit 27 calculates the open-circuit voltage of the cell 51 on the basis of the current, the voltage, and the internal resistance of the cell 51. The open-circuit voltage OCV of the cell 51 can be calculated by the formula OCV = V(t2) - I(t2) × R. The voltage V(t2) and the current I(t2) are the voltage and the current of the cell 51 at time t2 at which the standby time T elapses and at which the internal resistance R is calculated.

The state-of-charge calculation unit 14 calculates the state of charge of each of the plurality of cells 51. The state of charge is also referred to as SOC.

In the second embodiment, the contents of FIG. 4 of the first embodiment are used. As shown in FIG. 4, the state of charge increases as the open-circuit voltage of the cell 51 increases. The correlation between the open-circuit voltage and the state of charge illustrated in FIG. 4 may be stored in the storage unit 23, or may be calculated by a calculation circuit.

The state-of-charge calculation unit 14 can calculate the state of charge on the basis of the open-circuit voltage calculated by the open-circuit voltage calculation unit 27, by using the correlation shown in FIG. 4. With the above-described configuration, the state of charge of the cell 51 required for calculating the full charge capacity can be calculated.

The storage unit 22 stores therein the voltage acquired by the voltage acquisition unit 11, the current acquired by the current acquisition unit 12, the state of charge calculated by the state-of-charge calculation unit 14, the current accumulated value calculated by the current accumulated value calculation unit 23, the full charge capacity and the unit full charge capacity calculated by the full charge capacity calculation unit 16, the full charge capacity updated by the update unit 17, the statistical value calculated by the statistical value calculation unit 18, etc.

Next, operation of the battery monitoring device 120 of the present embodiment will be described.

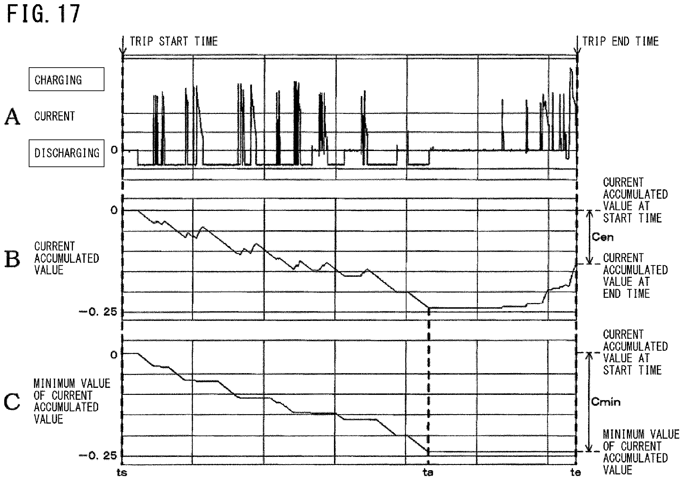

FIG. 17 is a time chart showing a first example of transition of a current accumulated value of the cell 51 of the present embodiment in one trip. In FIG. 17, the horizontal axis indicates time. Time ts indicates the start time of one trip, and time te indicates the end time of the one trip. Start time ts of the one trip can be a turn-on time at which the starting switch 68 is turned on from an OFF state, and end time te of the one trip can be a turn-off time at which the turned-on starting switch 68 is turned off. The turn-on time of the starting switch 68 can include not only a turn-on time but also a short period in the proximity of before and after the turn-on time (for example, a period corresponding to several sampling cycles of the voltage and the current of the cell 51). In addition, the turn-off time of the starting switch 68 can include not only a turn-off time but also a short period in the proximity of before and after the turn-off time.

The chart indicated by character A in FIG. 17 shows the charge/discharge current of the cell 51, the positive side with respect to 0 indicates that charging is being performed, and the negative side with respect to 0 indicates that discharging is being performed. The chart indicated by character B in FIG. 17 shows transition of the current accumulated value of the cell 51. In the chart indicated by character B in FIG. 17, the current accumulated value at start time ts is defined as 0, and the transition of the current accumulated value is represented by an amount of change from the current accumulated value at start time ts. The current accumulated value decreases during discharging, and increases during charging. The chart indicated by character C in FIG. 17 shows transition of the minimum value of the current accumulated value. In the chart indicated by character C in FIG. 17 as well, the transition of the minimum value is represented by an amount of change. The example of FIG. 17 shows the case where the current accumulated value at end time te is decreased from the current accumulated value at start time ts.

The control unit 10 determines whether the absolute value (Cen in the example of FIG. 17) of the difference between the current accumulated value at start time ts and the current accumulated value at end time te is smaller than a predetermined threshold. If the absolute value of the difference between the current accumulated value at start time ts and the current accumulated value at end time te is smaller than the predetermined threshold, there is a possibility that an error is included when the unit full charge capacity of the cell 51 is calculated.

If the absolute value of the difference between the current accumulated value at start time ts and the current accumulated value at end time te is smaller than the predetermined threshold, the specification unit 26 specifies a first time and a second time at which the absolute value of the difference between the current accumulated values is greater than that of the difference between the current accumulated value at start time ts and the current accumulated value at end time te, in the period from the start time ts to the end time te. In the present embodiment, a first time and a second time at which the absolute value of the difference between the current accumulated values becomes a maximum value are specified, but the first time and the second time are not limited thereto.

Accordingly, the difference ΔC in the current accumulated value can be inhibited from becoming small. As a result, the unit full charge capacity of the cell 51 and the full charge capacity of the secondary battery unit 50 can be accurately calculated.

In the example of FIG. 17, a minimum value Cmin of the current accumulated value is recorded, and thus the specification unit 26 specifies a minimum time at which the current accumulated value becomes a minimum value. If the minimum value continues over time, the minimum time may be a time at which the current accumulated value reaches the minimum value for the first time (time ta in the chart indicated by character C in FIG. 17), or may be any other time at which the minimum value is maintained.

More specifically, the specification unit 26 specifies the first time and the second time from start time ts, end time te, and minimum time ta. In the example of the chart indicated by character C in FIG. 17, the absolute value of the difference between the current accumulated value at start time ts and the current accumulated value at minimum time ta is greater than the absolute value of the difference between the current accumulated value at minimum time ta and the current accumulated value at end time te, and thus start time ts and minimum time ta are specified as the first time and the second time.

The state-of-charge calculation unit 14 calculates the states of charge of each of the plurality of cells 51 at start time ts and minimum time ta.

The state of charge at start time ts can be calculated, for example, as described below. Immediately before start time ts, the starting switch 68 has not been turned on, and the current flowing through the cell 51 can be ignored. In this case, the voltage of the cell 51 can be considered as the open-circuit voltage OCV, and thus the voltage of the cell 51 acquired in the sampling cycle immediately before start time ts is regarded as the open-circuit voltage OCV. Then, a state of charge SOC can be calculated from the acquired open-circuit voltage OCV by using the relationship shown in FIG. 4.

The state of charge at minimum time ta can be calculated by using the relationship shown in FIG. 4 and the open-circuit voltage OCV of the cell 51 calculated at the time at which the standby time T elapses from the charging/discharging switching time, in a period in the proximity of minimum time ta. In particular, the state of charge can be more accurately calculated by using the relationship shown in FIG. 4 and the open-circuit voltage OCV of the cell 51 calculated at the time at which the standby time T elapses from the charging/discharging switching time or at a time after and close to this time.

The full charge capacity calculation unit 16 calculates the unit full charge capacity of each of the plurality of cells 51 on the basis of the difference in the current accumulated value (charge/discharge amount) and the states of charge at the first time and the second time. When the difference in the current accumulated value is denoted by ΔC and the difference between the states of charge at the first time and the second time is denoted by ΔSOC, a unit full charge capacity F can be calculated by the formula ΔC/ΔSOC. The difference ΔC in the current accumulated value is also referred to as charge/discharge amount.

In the example of FIG. 17, the first time and the second time are start time ts and minimum time ta, and thus ΔC is (Cmin - Cst). Here, Cst is the current accumulated value at start time ts, and is defined as 0 in FIG. 17 for convenience. In addition, ΔSOC is (SOCmin - SOCst). Here, SOCmin is the SOC at minimum time ta, and SOCst is the SOC at start time ts.

As described above, even if the difference between the current accumulated value at the start time and the current accumulated value at the end time is small, the first time and the second time at which the absolute value of the difference between the current accumulated values becomes the maximum are specified, and thus the difference ΔC in the current accumulated value can be inhibited from becoming small. As a result, the unit full charge capacity of the cell 51 and the full charge capacity of the secondary battery unit 50 can be accurately calculated.

Moreover, even if the difference between the current accumulated value at the start time and the current accumulated value at the end time is small, the minimum time at which the current accumulated value becomes a minimum value is specified, and thus the difference ΔC in the current accumulated value can be inhibited from becoming small. As a result, the unit full charge capacity of the cell 51 and the full charge capacity of the secondary battery unit 50 can be accurately calculated.

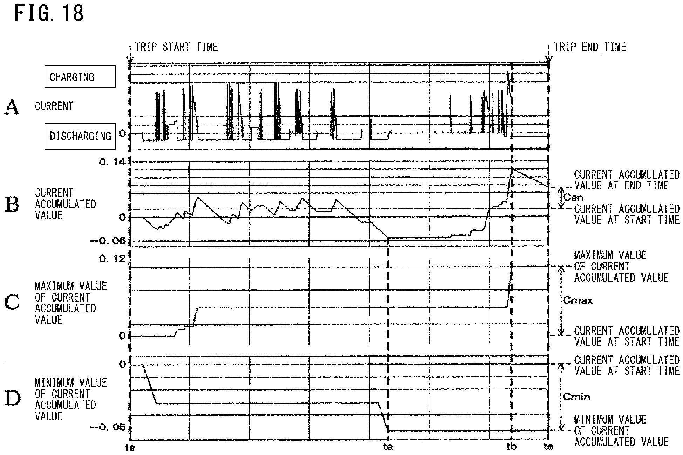

FIG. 18 is a time chart showing a second example of transition of a current accumulated value of the cell 51 of the present embodiment in one trip. In FIG. 18, the horizontal axis indicates time. Time ts indicates the start time of one trip, and time te indicates the end time of the one trip. The chart indicated by character A in FIG. 18 shows the charge/discharge current of the cell 51, the positive side with respect to 0 indicates that charging is being performed, and the negative side with respect to 0 indicates that discharging is being performed. The chart indicated by character B in FIG. 18 shows transition of the current accumulated value of the cell 51. In the chart indicated by character B in FIG. 18, the current accumulated value at start time ts is defined as 0, and the transition of the current accumulated value is represented by an amount of change from the current accumulated value at start time ts. The current accumulated value decreases during discharging, and increases during charging. The chart indicated by character C in FIG. 18 shows transition of the maximum value of the current accumulated value. The chart indicated by character D in FIG. 18 shows transition of the minimum value of the current accumulated value. In each of the chart indicated by character C in FIG. 18 and the chart indicated by character D in FIG. 18 as well, the transition of the maximum or minimum value is represented by an amount of change.

In the example of FIG. 18, not only a minimum value Cmin of the current accumulated value but also a maximum value Cmax of the current accumulated value is recorded, and the specification unit 22 specifies not only a minimum time at which the current accumulated value becomes a minimum value, but also a maximum time at which the current accumulated value becomes a maximum value. If the maximum value continues over time, the maximum time may be a time at which the current accumulated value reaches the maximum value for the first time (time tb in the chart indicated by character C in FIG. 18), or may be any other time at which the maximum value is maintained.

More specifically, the specification unit 26 specifies a first time and a second time from start time ts, end time te, and maximum time tb. In addition, in consideration of minimum time ta as well, the specification unit 26 can also specify a first time and a second time from start time ts, end time te, minimum time ta, and maximum time tb. In the example of FIG. 18, the absolute value of the difference between the current accumulated value at maximum time tb and the current accumulated value at minimum time ta is greatest, and thus minimum time ta and maximum time tb are specified as the first time and the second time.

Although not shown, if the transition of the current accumulated value is not less than the current accumulated value at start time ts (that is, if the minimum value is the current accumulated value at start time ts), there is no need to consider the minimum time.

The state-of-charge calculation unit 14 calculates the states of charge of each of the plurality of cells 51 at minimum time ta and maximum time tb. The state of charge at maximum time tb can be calculated by using the relationship shown in FIG. 4 and the open-circuit voltage OCV of the cell 51 calculated at the time at which the standby time T elapses from the charging/discharging switching time, in a period in the proximity of maximum time tb. In particular, the state of charge can be more accurately calculated by using the relationship shown in FIG. 4 and the open-circuit voltage OCV of the cell 51 calculated at the time at which the standby time T elapses from the charging/discharging switching time or at a time after and close to this time.

The state of charge at end time te can be calculated, for example, as described below. Immediately after end time te, the starting switch 68 has been turned off, and the current flowing through the cell 51 can be ignored. However, the voltage of the cell 51 may slowly change due to its relaxation and reduction. Thus, the voltage of the cell 51 acquired in the sampling cycle at a time at which a sufficient time elapses (for example, at a time immediately before the start of the next trip) rather than at a time immediately before end time te is regarded as the open-circuit voltage OCV. Then, a state of charge SOC can be calculated from the acquired open-circuit voltage OCV by using the relationship shown in FIG. 4. Accordingly, the state of charge can be more accurately calculated.

The full charge capacity calculation unit 16 calculates the unit full charge capacity of each of the plurality of cells 51 on the basis of the difference in the current accumulated value (charge/discharge amount) and the states of charge at the first time and the second time. When the difference in the current accumulated value is denoted by ΔC and the difference between the states of charge at the first time and the second time is denoted by ΔSOC, a unit full charge capacity F can be calculated by the formula ΔC/ΔSOC. The difference ΔC in the current accumulated value is also referred to as charge/discharge amount.

In the example of FIG. 18, the first time and the second time are minimum time ta and maximum time tb, and thus ΔC is (Cmax - Cmin). Here, Cmax is the current accumulated value at maximum time tb. In addition, ΔSOC is (SOCmax - SOCmin). Here, SOCmax is the SOC at maximum time tb.

As described above, even if the difference between the current accumulated value at the start time and the current accumulated value at the end time is small, the maximum time at which the current accumulated value becomes a maximum value is specified, and thus the difference ΔC in the current accumulated value can be inhibited from becoming small. As a result, the unit full charge capacity of the cell 51 and the full charge capacity of the secondary battery unit 50 can be accurately calculated.

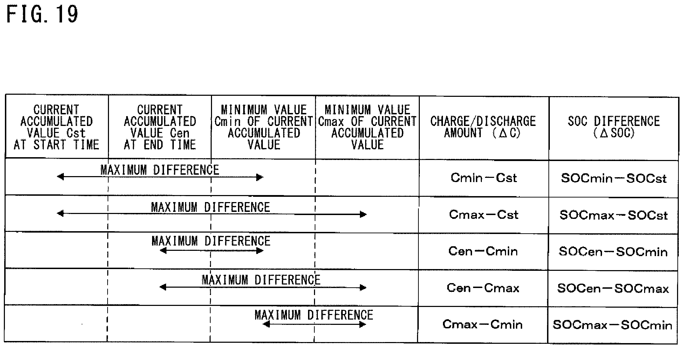

FIG. 19 illustrates a list of methods for calculating the charge/discharge amount ΔC and the difference ΔSOC in state of charge by the battery monitoring device 120 of the present embodiment. Possible candidates for the first time and the second time at which the absolute value of the difference between the current accumulated values becomes the maximum include start time ts, end time te, minimum time ta, and maximum time tb. As shown in FIG. 19, when the absolute value of the difference between the current accumulated value Cst at start time ts and the current accumulated value Cmin at minimum time ta becomes the maximum (maximum difference), the charge/discharge amount (ΔC) can be calculated by (Cmin - Cst), and the SOC difference (ΔSOC) can be calculated by (SOCmin - SOCst).

When the absolute value of the difference between the current accumulated value Cst at start time ts and the current accumulated value Cmax at maximum time tb becomes the maximum (maximum difference), the charge/discharge amount (ΔC) can be calculated by (Cmax - Cst), and the SOC difference (ΔSOC) can be calculated by (SOCmax - SOCst).

When the absolute value of the difference between the current accumulated value Cen at end time te and the current accumulated value Cmin at minimum time ta becomes the maximum (maximum difference), the charge/discharge amount (ΔC) can be calculated by (Cen - Cmin), and the SOC difference (ΔSOC) can be calculated by (SOCen - SOCmin).

When the absolute value of the difference between the current accumulated value Cen at end time te and the current accumulated value Cmax at maximum time tb becomes the maximum (maximum difference), the charge/discharge amount(ΔC) can be calculated by (Cen - Cmax), and the SOC difference (ΔSOC) can be calculated by (SOCen - SOCmax).

When the absolute value of the difference between the current accumulated value Cmax at maximum time tb and the current accumulated value Cmin at minimum time ta becomes the maximum (maximum difference), the charge/discharge amount (ΔC) can be calculated by (Cmax - Cmin), and the SOC difference (ΔSOC) can be calculated by (SOCmax - SOCmin).

The update unit 17 updates the full charge capacity of the secondary battery unit 50 on the basis of the unit full charge capacity calculated by the full charge capacity calculation unit 16. For example, when the secondary battery unit 50 is composed of cells 51 connected in series, if the variation of the unit full charge capacity of each cell 51 is within an allowable range, the full charge capacity of the secondary battery unit 50 can be the unit full charge capacities of the cells 51. As a result, the full charge capacity of the secondary battery unit 50 can be accurately calculated.

Moreover, the update unit 17 can update the unit full charge capacity of each cell 51 and the full charge capacity of the secondary battery unit 50 on the basis of a unit full charge capacity calculated by the full charge capacity calculation unit 16 at one time (for example, referred to as this time) and a unit full charge capacity calculated by the full charge capacity calculation unit 16 at a time previous to the one time (for example, referred to as last time).

For example, regarding an arbitrary cell 51, if the unit full charge capacity at this time is greater than the unit full charge capacity at the last time, it is considered that some error has occurred, in view of the fact that the full charge capacity decreases over time, and, thus, the unit full charge capacity at this time is not used, and the unit full charge capacity at the last time is used. On the other hand, if the unit full charge capacity at this time is equal to or less than the unit full charge capacity at the last time, the full charge capacity of the cell 51 is updated with the full charge capacity at this time. Accordingly, the unit full charge capacity of the cell 51 and the full charge capacity of the secondary battery unit 50 can be accurately updated.

When updating the unit full charge capacity of the cell 51, a statistical value of the unit full charge capacity can be used. Hereinafter, the case of using a statistical value will be described.

Each time the unit full charge capacity of each cell 51 is calculated by the full charge capacity calculation unit 16, the calculated unit full charge capacity is stored in the storage unit 22. For example, the calculated unit full charge capacity of each cell 51 can be stored so as to be associated with identification information (ID) of the cell 51.

The statistical value calculation unit 18 calculates a statistical value related to unit full charge capacity for each cell 51 on the basis of the unit full charge capacities for a predetermined number of times stored in the storage unit 22. The predetermined number of times can be, for example, 5 times, 10 times, or the like from this time (or present time) toward the past, but is not limited to 5 times and 10 times, and may be several times from the viewpoint of reducing errors. The statistical value can be, for example, an average value but is not limited to the average value.

For example, assuming that unit full charge capacities of an arbitrary cell 51 are Fn, F(n - 1), F(n - 2), F(n - 3), and F(n - 4) toward the past, the statistical value can be calculated by the formula, {Fn + F(n - 1) + F(n - 2) + F(n - 3) + F(n - 4)}/5.

The update unit 17 updates the full charge capacity of the secondary battery unit 50 on the basis of a statistical value calculated by the statistical value calculation unit 18 at one time (for example, referred to as this time) and a statistical value calculated by the statistical value calculation unit 18 at a time previous to the one time (for example, referred to as last time).

Regarding an arbitrary cell 51, if the statistical value of the unit full charge capacity at this time is greater than the statistical value of the unit full charge capacity at the last time, it is considered that some error has occurred, in view of the fact that the full charge capacity decreases over time, and thus the statistical value at this time is not used. On the other hand, if the statistical value of the unit full charge capacity at this time is equal to or less than the statistical value of the unit full charge capacity at the last time, the full charge capacity of the secondary battery unit 50 is updated using the statistical value at this time as the full charge capacity of the cell 51. Accordingly, an error can be reduced, and the full charge capacity of the secondary battery unit 50 can be accurately updated.

Moreover, the statistical value calculation unit 18 can calculate a statistical value related to unit full charge capacity on the basis of the minimum value, for each of a predetermined number of times in the past, among the respective unit full charge capacities of the plurality of cells 51 stored in the storage unit 22.

In the second embodiment, the contents of FIG. 7, FIG. 8, and FIG. 9 of the first embodiment are used. In FIG. 7, the unit full charge capacity of each cell 51 calculated and stored at each time is shown in the order of times tn, t(n - 1), t(n - 2), t(n - 3), t(n - 4), t(n - 5), ... toward the past. For example, the unit full charge capacities of the cells 1 to 5 are represented as F1n, F2n, F3n, F4n, and F5n at time tn, and the unit full charge capacities of the cells 1 to 5 are represented as F1(n - 1), F2(n - 1), F3(n - 1), F4(n - 1), and F5(n - 1) at time t(n - 1). The same applies to the other times. In addition, in FIG. 7, circled values indicate minimum values. For example, it is indicated that, among the unit full charge capacities F1n, F2n, F3n, F4n, and F5n of the cells 1 to 5 at time tn, F2n is the minimum value. The same applies to the other times.

In the case of FIG. 7, the statistical value calculation unit 18 calculates a statistical value FSn at time tn by the formula, FSn = {F2n + F2(n - 1) + F2(n - 2) + F3(n - 3) + F2(n - 4)}/5. In addition, the statistical value calculation unit 18 calculates a statistical value FS(n - 1) at time t(n - 1) by the formula, FS(n - 1) = {F2(n - 1) + F2(n - 2) + F3(n - 3) + F2(n - 4) + F2(n - 5)}/5.

When the respective unit full charge capacities of the plurality of cells 51 are different, the full charge capacity of the secondary battery unit 50 often depends on the minimum value of the unit full charge capacities of the plurality of cells 51. With the above-described configuration, the full charge capacity of the secondary battery unit 50 in which the plurality of cells 51 are connected in series can be accurately obtained.

Next, the method for updating the full charge capacity of the secondary battery unit 50 will be described.

As shown in FIG. 8, if the statistical value at this time is greater than the statistical value at the last time, the update unit 17 does not update the full charge capacity of the secondary battery unit 50. For example, if the statistical value of the unit full charge capacity at this time is greater than the statistical value of the unit full charge capacity at the last time, it is considered that some error has occurred, in view of the fact that the unit full charge capacity (full charge capacity) decreases over time, and, thus, the statistical value at this time is not used, and the full charge capacity of the secondary battery unit 50 is not updated. Accordingly, the accuracy of the full charge capacity of the secondary battery unit 50 can be prevented from decreasing.

Moreover, as shown in FIG. 8, if the statistical value at this time is equal to or less than the statistical value at the last time, the update unit 17 updates the full charge capacity of the secondary battery unit 50 on the basis of the statistical value at this time. For example, if the statistical value of the unit full charge capacity at this time is equal to or less than the statistical value of the unit full charge capacity at the last time, since the full charge capacity of the secondary battery unit 50 is updated, the full charge capacity that decreases over time can be reflected and the full charge capacity of the secondary battery unit 50 can be accurately obtained.

As shown in FIG. 9, if the statistical value at an arbitrary time is greater than the nominal full charge capacity, the update unit 17 updates the full charge capacity of the secondary battery unit 50 on the basis of the statistical value at this time.

The actual full charge capacity (actual value) of a battery is generally greater than the nominal full charge capacity thereof in consideration of variations in battery production and the like. In particular, when the cell 51 (or the secondary battery unit 50) is new or nearly new, the unit full charge capacity of the cell 51 is often greater than the nominal full charge capacity thereof. Therefore, if the statistical value is greater than the nominal full charge capacity, the full charge capacity of the secondary battery unit 50 is updated on the basis of the statistical value.

For example, assuming that the nominal full charge capacity is FN and the calculated full charge capacity of the secondary battery unit 50 is F (= FN + ΔF), by setting the full charge capacity of the secondary battery unit 50 to F and not to FN, it is made possible to perform regeneration by the capacity corresponding to ΔF, so that the range where regeneration is possible can be expanded.

Moreover, as shown in FIG. 9, if the statistical value at this time is equal to or less than the nominal full charge capacity and greater than the statistical value at the last time, the update unit 17 does not update the full charge capacity of the secondary battery unit 50. If the statistical value is equal to or less than the nominal full charge capacity, there is no room to expand the range where regeneration is possible, as when the statistical value is greater than the nominal full charge capacity. Furthermore, if the statistical value of the unit full charge capacity at this time is greater than the statistical value of the unit full charge capacity at the last time, it is considered that some error has occurred, and, thus, the statistical value at this time is not used, and the full charge capacity of the secondary battery unit 50 is not updated. Accordingly, the accuracy of the full charge capacity of the secondary battery unit 50 can be prevented from decreasing.

Moreover, as shown in FIG. 9, if the statistical value at this time is equal to or less than the nominal full charge capacity and equal to or less than the statistical value at the last time, the update unit 17 updates the full charge capacity of the secondary battery unit 50 on the basis of the statistical value. If the statistical value is equal to or less than the nominal full charge capacity, there is no room to expand the range where regeneration is possible, as when the statistical value is greater than the nominal full charge capacity. Furthermore, if the statistical value of the unit full charge capacity at this time is equal to or less than the statistical value of the unit full charge capacity at the last time, since the full charge capacity of the secondary battery unit 50 is updated, the full charge capacity that decreases over time can be reflected and the full charge capacity of the secondary battery unit 50 can be accurately obtained.

Moreover, by grasping the initial full charge capacity of the secondary battery unit 50 and comparing the initial full charge capacity with the nominal full charge capacity, the degree of deterioration of the secondary battery unit 50 can also be accurately grasped.

Next, operation of the battery monitoring device 120 of the present embodiment will be described.

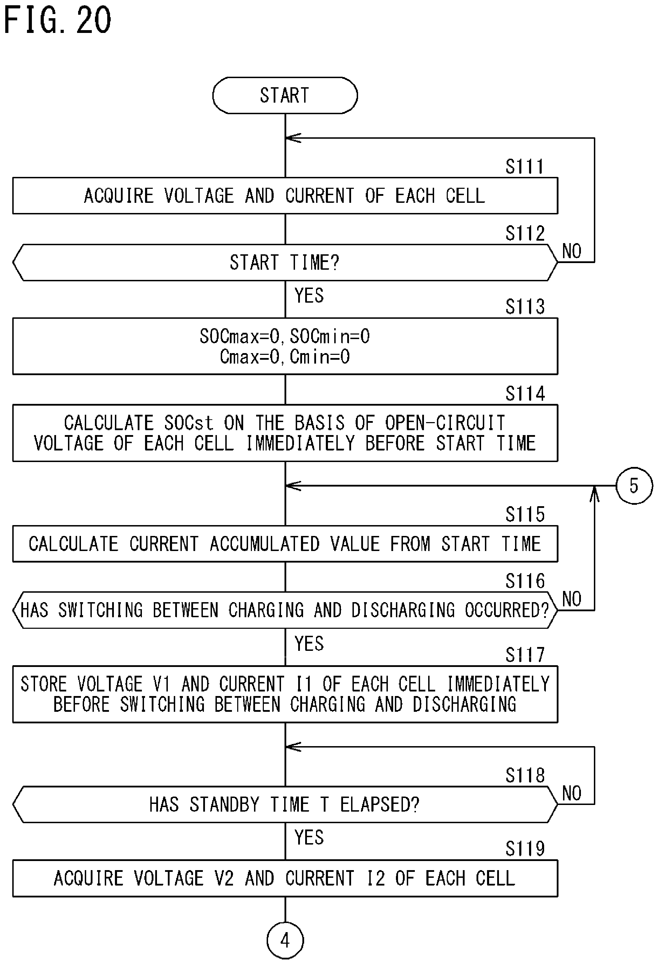

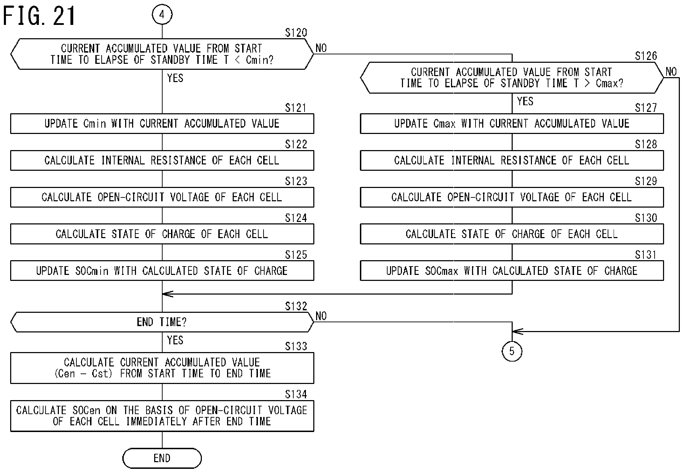

FIG. 20 and FIG. 21 are flowcharts showing an example of a process procedure for calculating a state of charge and a current accumulated value by the battery monitoring device 120 of the present embodiment. Hereinafter, for convenience, a description will be given with the control unit 10 as the subject of the process. The control unit 10 acquires the voltage and the current of each cell 51 (S111) and determines whether the present time is the start time of a trip (S112). If the present time is not start time ts (NO in S112), the control unit 10 continues the processes in step S111 and the subsequent step.

If the present time is the start time (YES in S112), the control unit 10 sets SOCmax = 0, SOCmin = 0, Cmax = 0, and Cmin = 0 (S113). The control unit 10 calculates a state of charge SOCst at start time ts on the basis of the open-circuit voltage of each cell 51 immediately before start time ts (S114).

The control unit 10 calculates a current accumulated value from start time ts (S115) and determines presence/absence of switching between charging and discharging of the secondary battery unit 50 (S116). If switching between charging and discharging has not occurred (NO in S116), the control unit 10 continues the processes in step S115 and the subsequent step. If switching between charging and discharging has occurred (YES in S116), the control unit 10 stores a voltage V1 and a current I1 of each cell 51 immediately before the switching between charging and discharging (S117).

The control unit 10 determines whether the standby time T has elapsed from the time of switching between charging and discharging (S118). If the standby time T has not elapsed (NO in S118), the control unit 10 continues the process in step S118. If the standby time T has elapsed (YES in S118), the control unit 10 acquires a voltage V2 and a current I2 of each cell 51 (S119).

The control unit 10 determines whether the current accumulated value from start time ts to the elapse of the standby time T is smaller than Cmin (S120). If the current accumulated value is smaller than Cmin (YES in S120), the control unit 10 updates Cmin with the current accumulated value (S121). That is, the control unit 10 sets the current accumulated value as Cmin. The control unit 10 calculates the internal resistance R of each cell 51 (S122). The internal resistance R can be calculated by the formula R = (V2 - V1)/(I2 - I1).

The control unit 10 calculates the open-circuit voltage of each cell 51 (S123). The open-circuit voltage OCV can be calculated by the formula OCV = V2 - I2 × R. The control unit 10 calculates a state of charge on the basis of the calculated open-circuit voltage (S124), and updates SOCmin with the calculated state of charge (S125). That is, the control unit 10 sets the calculated state of charge as SOCmin. The control unit 10 performs a process in step S132 described later.

If the current accumulated value is not smaller than Cmin (NO in S120), the control unit 10 determines whether the current accumulated value from start time ts to the elapse of the standby time T is greater than Cmax (S126). If the current accumulated value is greater than Cmax (YES in S126), the control unit 10 updates Cmax with the current accumulated value (S127). That is, the control unit 10 sets the current accumulated value as Cmax. The control unit 10 calculates the internal resistance R of each cell 51 (S128).

The control unit 10 calculates the open-circuit voltage of each cell 51 (S129). The control unit 10 calculates a state of charge on the basis of the calculated open-circuit voltage (S130), and updates SOCmax with the calculated state of charge (S131). That is, the control unit 10 sets the calculated state of charge as SOCmax.

The control unit 10 determines whether the present time is end time te of the trip (S132). If the present time is not end time te (NO in S132), the control unit 10 continues the processes in step S115 and the subsequent steps. In addition, if the current accumulated value is not greater than Cmax (NO in S126), the control unit 10 continues the processes in step S115 and the subsequent steps.

If the present time is end time te (YES in S132), the control unit 10 calculates a current accumulated value (Cen - Cst) from start time ts to end time te (S133), calculates a state of charge SOCen on the basis of the open-circuit voltage of each cell immediately after end time te (S134), and ends the process.

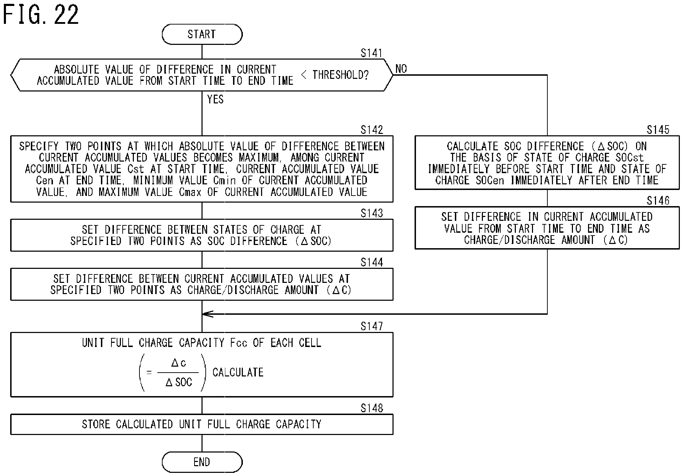

FIG. 22 is a flowchart showing an example of a process procedure for calculating a unit full charge capacity by the battery monitoring device 120 of the present embodiment. The control unit 10 determines whether the absolute value of the difference (Cen - Cst) in the current accumulated value from start time ts to end time te is smaller than a threshold (S141). If the absolute value of the difference in the current accumulated value is smaller than the threshold (YES in S141), the control unit 10 specifies two points at which the absolute value of the difference between the current accumulated values becomes the maximum, among the current accumulated value Cst at start time ts, the current accumulated value Cen at end time te, the minimum value Cmin of the current accumulated value, and the maximum value Cmax of the current accumulated value (S142).

The control unit 10 sets the difference between the states of charge at the specified two points as an SOC difference (ΔSOC) (S143), sets the difference between the current accumulated values at the specified two points as a charge/discharge amount (ΔC) (S144), and performs a process in step S147 described later.

If the absolute value of the difference between the current accumulated values is not smaller than the threshold (NO in S141), the control unit 10 calculates an SOC difference (ΔSOC) on the basis of the state of charge SOCst immediately before start time ts and the state of charge SOCen immediately after end time te (S 145), and sets the difference (Cen - Cst) in the current accumulated value from start time ts to end time te as a charge/discharge amount (ΔC) (S146).

The control unit 10 calculates a unit full charge capacity FCC of each cell 51 by the formula FCC = ΔC/ΔSOC (S147), stores the calculated unit full charge capacity in the storage unit 23 (S148), and ends the process.

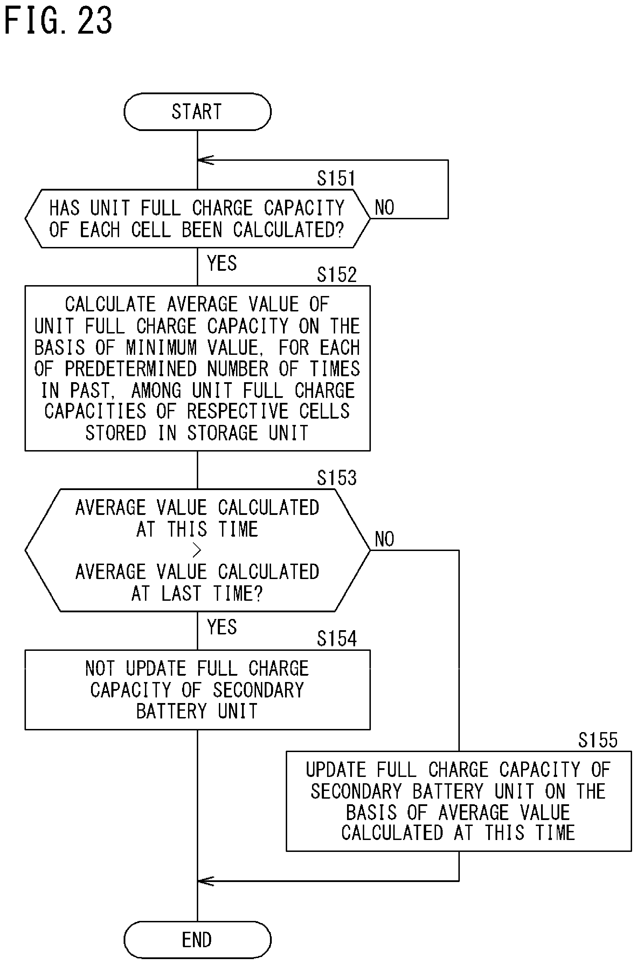

FIG. 23 is a flowchart showing an example of a process of updating the full charge capacity by the battery monitoring device 120 of the present embodiment. The control unit 10 determines whether the unit full charge capacity of each cell 51 has been calculated (S151). If the unit full charge capacity has not been calculated (NO in S151), the control unit 10 continues the process in step S151.

If the unit full charge capacity has been calculated (YES in S151), the control unit 10 calculates the average value of the unit full charge capacity on the basis of the minimum value, for each of a predetermined number of times in the past, among the unit full charge capacities of the respective cells 51 stored in the storage unit 23 (S152).

The control unit 10 determines whether the average value calculated at this time is greater than the average value calculated at the last time (S153). If the average value calculated at this time is greater than the average value calculated at the last time (YES in S153), the control unit 10 does not update the full charge capacity of the secondary battery unit 50 (S154) and ends the process.

If the average value calculated at this time is not greater than the average value calculated at the last time (NO in S 153), the control unit 10 updates the full charge capacity of the secondary battery unit 50 on the basis of the average value calculated at this time (S155) and ends the process.

The battery monitoring device 100 of the present embodiment can also be realized by using a general purpose computer including a CPU (processor), a RAM (memory), etc. That is, the battery monitoring device 100 can be realized on the computer by loading a computer program defining the process procedures as shown in FIG. 20 to FIG. 23 onto the RAM (memory) included in the computer, and executing the computer program by the CPU (processor).

The disclosed embodiments are illustrative in all aspects and should not be recognized as being restrictive. The scope of the present disclosure is defined by the scope of the claims rather than the above description, and is intended to include meaning equivalent to the scope of the claims and all modifications within the scope.

### REFERENCE SIGNS LIST

- 10: control unit
- 11: voltage acquisition unit
- 12: current acquisition unit
- 13: temperature acquisition unit
- 14: state-of-charge calculation unit
- 15: charge/discharge amount calculation unit
- 16: full charge capacity calculation unit
- 17: update unit
- 18: statistical value calculation unit
- 19: timer
- 20: interface unit
- 21: voltage change rate calculation unit
- 22: storage unit
- 23: current accumulated value calculation unit
- 24: resistance calculation unit
- 25: switching determination unit
- 26: specification unit
- 27: open-circuit voltage calculation unit
- 50: secondary battery unit
- 51: cell
- 52: voltage sensor
- 53: current sensor
- 100: battery monitoring device

## Claims

1. A battery monitoring device for monitoring a full charge capacity of a secondary battery including a plurality of unit cells, the battery monitoring device comprising:
a voltage acquisition unit configured to acquire voltages of the plurality of unit cells;
a current acquisition unit configured to acquire a charge/discharge current of the secondary battery;
a first state-of-charge calculation unit configured to calculate a first state of charge on the basis of a first voltage acquired by the voltage acquisition unit at a first time at which a predetermined switch for charging/discharging operation of the secondary battery is in an OFF state, in a first trip period from a turn-on time of the predetermined switch to a next turn-on time of the predetermined switch;
a second state-of-charge calculation unit configured to calculate a second state of charge on the basis of a second voltage acquired by the voltage acquisition unit at a second time at which the predetermined switch is in an OFF state, in a second trip period that is a trip period next to the first trip period;
a charge/discharge amount calculation unit configured to calculate a charge/discharge amount of the secondary battery on the basis of the charge/discharge current acquired by the current acquisition unit from the first time to the second time;
a full charge capacity calculation unit configured to calculate a unit full charge capacity of each of the plurality of unit cells on the basis of the first state of charge, the second state of charge, and the charge/discharge amount; and
an update unit configured to update the full charge capacity of the secondary battery on the basis of the unit full charge capacity calculated by the full charge capacity calculation unit.

2. The battery monitoring device according to claim 1, wherein the update unit updates the full charge capacity of the secondary battery on the basis of a unit full charge capacity calculated by the full charge capacity calculation unit at one time and a unit full charge capacity calculated by the full charge capacity calculation unit at a time previous to the one time.

3. The battery monitoring device according to claim 1, further comprising:
a storage unit configured to store the unit full charge capacity of each of the plurality of unit cells each time the unit full charge capacity of each of the plurality of unit cells is calculated by the full charge capacity calculation unit; and
a statistical value calculation unit configured to calculate a statistical value related to unit full charge capacity on the basis of unit full charge capacities for a predetermined number of times in the past stored in the storage unit, wherein
the update unit updates the full charge capacity of the secondary battery on the basis of a statistical value calculated by the statistical value calculation unit at one time and a statistical value calculated by the statistical value calculation unit at a time previous to the one time.

4. The battery monitoring device according to claim 3, wherein, if the statistical value at the one time is greater than the statistical value at the previous time, the update unit does not update the full charge capacity of the secondary battery.

5. The battery monitoring device according to claim 3 or 4, wherein, if the statistical value at the one time is equal to or less than the statistical value at the previous time, the update unit updates the full charge capacity of the secondary battery on the basis of the statistical value.

6. The battery monitoring device according to claim 3, wherein, if the statistical value at the one time is greater than a nominal full charge capacity, the update unit updates the full charge capacity of the secondary battery on the basis of the statistical value.

7. The battery monitoring device according to claim 6, wherein, if the statistical value at the one time is equal to or less than the nominal full charge capacity and greater than the statistical value at the previous time, the update unit does not update the full charge capacity of the secondary battery.

8. The battery monitoring device according to claim 6 or 7, wherein, if the statistical value at the one time is equal to or less than the nominal full charge capacity and equal to or less than the statistical value at the previous time, the update unit updates the full charge capacity of the secondary battery on the basis of the statistical value.

9. The battery monitoring device according to any one of claims 3 to 8, wherein the statistical value calculation unit calculates a statistical value related to unit full charge capacity on the basis of a minimum value, for each of the predetermined number of times in the past, among the respective unit full charge capacities of the plurality of unit cells stored in the storage unit.

10. The battery monitoring device according to any one of claims 1 to 9, wherein the voltage acquisition unit acquires the first voltage and the second voltage except a voltage acquired by the secondary battery during charging or during discharging.

11. The battery monitoring device according to any one of claims 1 to 10, wherein the voltage acquisition unit acquires the first voltage and the second voltage except a voltage acquired within a predetermined period from end of charging or discharging of the secondary battery or within a predetermined period from a turn-off time of the predetermined switch.

12. The battery monitoring device according to any one of claims 1 to 10, further comprising a voltage change rate calculation unit configured to calculate a voltage change rate of each of the plurality of unit cells after end of charging or discharging of the secondary battery or after a turn-off time of the predetermined switch, wherein
the voltage acquisition unit acquires the first voltage and the second voltage except a voltage acquired when the voltage change rate calculated by the voltage change rate calculation unit is equal to or greater than a predetermined value.

13. The battery monitoring device according to any one of claims 1 to 12, further comprising a signal acquisition unit configured to acquire a signal related to balancing operation of remaining capacities of the plurality of unit cells, wherein
the voltage acquisition unit acquires the first voltage and the second voltage except a voltage acquired when the signal acquired by the signal acquisition unit indicates that the balancing operation is being performed.

14. A computer program for causing a computer to monitor a full charge capacity of a secondary battery including a plurality of unit cells, the computer program causing the computer to perform:
a process of acquiring voltages of the plurality of unit cells;
a process of acquiring a charge/discharge current of the secondary battery;
a process of calculating a first state of charge on the basis of a voltage acquired at a first time at which a predetermined switch for charging/discharging operation of the secondary battery is in an OFF state, in a first trip period from a turn-on time of the predetermined switch to a next turn-on time of the predetermined switch;
a process of calculating a second state of charge on the basis of a voltage acquired at a second time at which the predetermined switch is in an OFF state, in a second trip period that is a trip period next to the first trip period;
a process of calculating a charge/discharge amount of the secondary battery on the basis of the charge/discharge current acquired from the first time to the second time;
a process of calculating a unit full charge capacity of each of the plurality of unit cells on the basis of the first state of charge, the second state of charge, and the charge/discharge amount; and
a process of updating the full charge capacity of the secondary battery on the basis of the calculated unit full charge capacity.

15. A battery monitoring method by a battery monitoring device for monitoring a full charge capacity of a secondary battery including a plurality of unit cells, the battery monitoring method comprising:
acquiring voltages of the plurality of unit cells;
acquiring a charge/discharge current of the secondary battery;
calculating a first state of charge on the basis of a voltage acquired at a first time at which a predetermined switch for charging/discharging operation of the secondary battery is in an OFF state, in a first trip period from a turn-on time of the predetermined switch to a next turn-on time of the predetermined switch;
calculating a second state of charge on the basis of a voltage acquired at a second time at which the predetermined switch is in an OFF state, in a second trip period that is a trip period next to the first trip period;
calculating a charge/discharge amount of the secondary battery on the basis of the charge/discharge current acquired from the first time to the second time;
calculating a unit full charge capacity of each of the plurality of unit cells on the basis of the first state of charge, the second state of charge, and the charge/discharge amount; and
updating the full charge capacity of the secondary battery on the basis of the calculated unit full charge capacity.

16. A battery monitoring device for monitoring a full charge capacity of a secondary battery including a plurality of unit cells, the battery monitoring device comprising:
a current acquisition unit configured to acquire a current of the secondary battery;
a current accumulated value calculation unit configured to calculate a current accumulated value of the secondary battery from a predetermined start time to an end time;
a specification unit configured to specify a first time and a second time on the basis of an absolute value of a difference in the current accumulated value calculated by the current accumulated value calculation unit;
a state-of-charge calculation unit configured to calculate states of charge of each of the plurality of unit cells at the first time and the second time specified by the specification unit; and
a full charge capacity calculation unit configured to calculate a unit full charge capacity of each of the plurality of unit cells on the basis of the difference in the current accumulated value and the states of charge at the first time and the second time.

17. The battery monitoring device according to claim 16, further comprising a minimum value specification unit configured to specify a minimum time at which the current accumulated value calculated by the current accumulated value calculation unit becomes a minimum value, wherein
the specification unit specifies the first time and the second time from the start time, the end time, and the minimum time.

18. The battery monitoring device according to claim 16 or 17, further comprising a maximum value specification unit configured to specify a maximum time at which the current accumulated value calculated by the current accumulated value calculation unit becomes a maximum value, wherein
the specification unit specifies the first time and the second time from the start time, the end time, and the maximum time.

19. The battery monitoring device according to any one of claims 16 to 18, further comprising:
a voltage acquisition unit configured to acquire voltages of the plurality of unit cells;
a resistance calculation unit configured to calculate internal resistances of the plurality of unit cells; and
an open-circuit voltage calculation unit configured to calculate open-circuit voltages of the plurality of unit cells on the basis of the current of the secondary battery and the voltages and the internal resistances of the plurality of unit cells, wherein
the state-of-charge calculation unit calculates the states of charge on the basis of the open-circuit voltages calculated by the open-circuit voltage calculation unit.

20. The battery monitoring device according to any one of claims 16 to 19, wherein, if an absolute value of a difference between a current accumulated value calculated by the current accumulated value calculation unit at the start time and a current accumulated value calculated by the current accumulated value calculation unit at the end time is smaller than a predetermined threshold, the specification unit specifies the first time and the second time.

21. The battery monitoring device according to any one of claims 16 to 20, further comprising an update unit configured to update the full charge capacity of the secondary battery on the basis of the unit full charge capacity calculated by the full charge capacity calculation unit.

22. The battery monitoring device according to claim 21, wherein the update unit updates the full charge capacity of the secondary battery on the basis of a unit full charge capacity calculated by the full charge capacity calculation unit at one time and a unit full charge capacity calculated by the full charge capacity calculation unit at a time previous to the one time.

23. The battery monitoring device according to claim 21, further comprising:
a storage unit configured to store the unit full charge capacity of each of the plurality of unit cells each time the unit full charge capacity of each of the plurality of unit cells is calculated by the full charge capacity calculation unit; and
a statistical value calculation unit configured to calculate a statistical value related to unit full charge capacity on the basis of unit full charge capacities for a predetermined number of times in the past stored in the storage unit, wherein
the update unit updates the full charge capacity of the secondary battery on the basis of a statistical value calculated by the statistical value calculation unit at one time and a statistical value calculated by the statistical value calculation unit at a time previous to the one time.

24. The battery monitoring device according to claim 23, wherein, if the statistical value at the one time is greater than the statistical value at the previous time, the update unit does not update the full charge capacity of the secondary battery.

25. The battery monitoring device according to claim 23 or 24, wherein the statistical value calculation unit calculates a statistical value related to unit full charge capacity on the basis of a minimum value, for each of the predetermined number of times in the past, among the respective unit full charge capacities of the plurality of unit cells stored in the storage unit.

26. A computer program for causing a computer to monitor a full charge capacity of a secondary battery including a plurality of unit cells, the computer program causing the computer to perform:
a process of acquiring a current of the secondary battery;
a process of calculating a current accumulated value of the secondary battery from a predetermined start time to an end time;
a process of specifying a first time and a second time on the basis of an absolute value of a difference in the calculated current accumulated value;
a process of calculating states of charge of each of the plurality of unit cells at the specified first time and second time; and
a process of calculating a unit full charge capacity of each of the plurality of unit cells on the basis of the absolute value of the difference in the current accumulated value and the states of charge at the first time and the second time.

27. A battery monitoring method by a battery monitoring device for monitoring a full charge capacity of a secondary battery including a plurality of unit cells, the battery monitoring method comprising:
acquiring a current of the secondary battery;
calculating a current accumulated value of the secondary battery from a predetermined start time to an end time;
specifying a first time and a second time on the basis of an absolute value of a difference in the calculated current accumulated value;
calculating states of charge of each of the plurality of unit cells at the specified first time and second time; and
calculating a unit full charge capacity of each of the plurality of unit cells on the basis of the absolute value of the difference in the current accumulated value and the states of charge at the first time and the second time.
